# EUROPEAN PATENT SPECIFICATION

(11) **EP 4 187 320 B1**
(45) Date of publication and mention of the grant of the patent: **03.06.2026**
(21) Application number: 22208875.9
(22) Date of filing: 22.11.2022
(51) Int. Cl.: G03F 7/09, G03F 7/11

(54) **MATERIAL FOR FORMING ORGANIC FILM, SUBSTRATE FOR MANUFACTURING SEMICONDUCTOR DEVICE, METHOD FOR FORMING ORGANIC FILM, AND PATTERNING PROCESS**
MATERIAL ZUR BILDUNG EINES ORGANISCHEN FILMS, SUBSTRAT ZUR HERSTELLUNG EINES HALBLEITERBAUELEMENTS, VERFAHREN ZUR BILDUNG EINES ORGANISCHEN FILMS UND STRUKTURIERUNGSVERFAHREN
MATÉRIAU POUR FORMER UN FILM ORGANIQUE, SUBSTRAT POUR FABRIQUER UN DISPOSITIF À SEMI-CONDUCTEUR, PROCÉDÉ DE FORMATION D'UN FILM ORGANIQUE ET PROCÉDÉ DE FORMATION DE MOTIFS

(30) Priority: 25.11.2021 JP 2021191479
(43) Date of publication of application: 31.05.2023
(73) Proprietor: Shin-Etsu Chemical Co., Ltd., Tokyo 100-0005 (JP)
(72) Inventor: Niida, Keisuke, Niigata (JP); Yamamoto, Yasuyuki, Niigata (JP)
(74) Representative: Sonnenhauser, Thomas Martin

(56) References cited:
- JP-A- 2005 041 938
- US-A1- 2005 215 732
- US-A1- 2017 183 531
- US-A1- 2017 184 968
- US-B1- 9 620 378

## Description

### TECHNICAL FIELD

The present invention relates to: a material for forming an organic film used in a semiconductor device manufacturing process; and a substrate for manufacturing a semiconductor device, a method for forming an organic film, and a patterning process according to a multilayer resist method which use the material.

### BACKGROUND ART

As LSI advances toward high integration and high processing speed, miniaturization of pattern size is progressing rapidly. Along with this miniaturization, lithography technology has achieved fine patterning by shortening the wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble. Thereby, a pattern is formed by dissolving the exposed part, and the remaining resist pattern is used as an etching mask to process a substrate to be processed by dry etching.

However, when the pattern becomes finer, that **is,** the pattern width is reduced without changing the thickness of the photoresist film to be used, resolution performance of the photoresist film is lowered. In addition, pattern development of the photoresist film with a developer excessively increases what is called an aspect ratio, resulting in pattern collapse problem. Therefore, photoresist films have been thinned along with the pattern miniaturization.

On the other hand, a substrate to be processed has been generally processed by dry etching using a pattern-formed photoresist film as an etching mask. In practice, however, there is no dry etching method capable of providing an absolute etching selectivity between the photoresist film and the substrate to be processed. Hence, there are problems that the photoresist film is damaged and collapses during processing of the substrate, and that the resist pattern cannot be precisely transferred to the substrate to be processed. Accordingly, resist compositions have been required to have higher dry etching resistance along with the pattern miniaturization. Meanwhile, to enhance the resolution, resins used for photoresist compositions have been required to have low absorbance at the exposure wavelength. Accordingly, as the exposure light shifts to shorter wavelengths from i-beam to KrF and to ArF, the resin shifts to novolak resins, polyhydroxystyrene, and resins having aliphatic polycyclic skeletons. This shift actually accelerates an etching rate under dry etching conditions in processing the substrate, and recent photoresist compositions for high resolution tend to have low etching resistance.

As a result, a substrate to be processed has to be dry etched with a thinner photoresist film having lower etching resistance. It is important to establish a material and procedure reliably for this processing.

A multilayer resist method is one solution for these problems. This method is as follows: a resist middle layer film having a different etching selectivity from a photoresist film (i.e., a resist upper layer film) is placed between the resist upper layer film and a substrate to be processed; a pattern is formed in the resist upper layer film; then, the pattern is transferred to the resist middle layer film by dry etching using the resist upper layer film pattern as a dry etching mask; and the pattern is further transferred to the substrate to be processed by dry etching using the resist middle layer film as a dry etching mask.

One of the multilayer resist methods is a three-layer resist method, which can be performed with a typical resist composition used in the monolayer resist method. This three-layer resist method includes, for example, the following steps: an organic film made of a novolak resin or the like is formed as a resist underlayer film on a substrate to be processed; a silicon-containing resist middle layer film is formed as a resist middle layer film on the resist underlayer film; a usual organic photoresist film is formed as a resist upper layer film on the resist middle layer film. Since the organic resist upper layer film exhibits a favorable etching selectivity ratio relative to the silicon-containing resist middle layer film when dry etching is performed with fluorine-based gas plasma, the resist upper layer film pattern can be transferred to the silicon-containing resist middle layer film by employing dry etching with fluorine-based gas plasma. According to this method, even if a resist composition to be used has difficulty in forming a pattern with a sufficient film thickness for directly processing the substrate to be processed or has insufficient dry etching resistance for processing the substrate, the pattern can be transferred to the silicon-containing resist middle layer film (resist middle layer film). Moreover, the subsequent dry etching with oxygen-based or hydrogen-based gas plasma enables the pattern to be transferred into the organic film (resist underlayer film) made of a novolak resin or the like having a sufficient dry etching resistance for processing the substrate. Numerous resist underlayer films as described above have been already known and disclosed in, for example, Patent Document 1, etc.

Meanwhile, in recent years, semiconductor devices having novel structures, such as multi-gate structure, have been actively manufactured and studied. Accordingly, there are growing needs for a resist underlayer film having more excellent planarizing and filling properties than conventional ones. For example, when a substrate to be processed used as a base has a fine pattern structure, such as holes, trenches, and fins, a resist underlayer film is required to have gap-filling property in order to fill the gaps in the pattern without voids. In addition, when the underlying substrate to be processed has a step(s) or when both a pattern-dense portion and a pattern-free region exist in one wafer, the film surface needs to be planarized (planarization) by a resist underlayer film. Having the resist underlayer film with flat surface can suppress fluctuation in film thickness of a resist middle layer film and a resist upper layer film formed thereon, and suppress the reductions of a focus margin in lithography or margin in a subsequent step of processing the substrate to be processed.

Moreover, the organic film material excellent in filling property and planarizing property is not limited to the usage as the underlayer film for multilayer resist, and is also widely usable as a planarizing material for manufacturing a semiconductor device, e.g., for planarizing a substrate prior to patterning by nanoimprinting, etc. Further, a CMP process is now generally used for global planarization in a semiconductor device manufacturing process. However, the CMP process is costly, so that such organic film material excellent in filling property and planarizing property is also expected as a material employed in the global planarizing method, instead of CMP.

To form a planarizing film for planarizing an uneven semiconductor substrate, there is proposed an organic film material that contains a compound with a certain structure containing linear ether moieties and aromatic moieties having triple bonds at terminals (Patent Document 2). Further, organic film materials utilizing triple bond as intermolecular crosslinking group in the curable resins are known from Patent Documents 3 to 14, etc. However, these materials do not exhibit sufficient planarizing performance or the like on a wide trench portion in a substrate, and do not satisfy needs in cutting-edge devices. There have been demands for an organic film material having excellent planarizing property on a variety of substrate structures.

Furthermore, a process has been studied in which an organic film is formed by spin coating and an inorganic hard mask middle layer film is formed thereon as a resist middle layer film by a CVD method. When an inorganic hard mask middle layer film is formed by a CVD method, particularly when a nitride-based film is to be formed, the substrate has to be heated at 300°C at the lowest, generally 400°C. Hence, when an organic film is formed by spin-coating method, heat resistance to 400°C is required. However, even common cresol novolak, naphthol novolak, and fluorene bisphenol having high heat resistance cannot withstand heating at 400°C, resulting in great film reductions after heating. In this manner, there have been demands also for an organic film that can withstand high-temperature heating for forming an inorganic hard mask middle layer film by a CVD method. JP 2005 041938 A discloses an organic insulating film-forming composition which can form organic insulating films having high mechanical strength, wherein the organic insulating film-forming composition is characterized by containing a compound having at least three -C≡CH groups in the molecule, further a method for producing an organic insulating film which is characterized by comprising a process for coating a composition described above on a substrate and then thermally treating the coated composition at an oxygen concentration of <1 %, further an organic insulating film obtained by the production method described above, further an organic insulating film as described above, wherein the hardness and elastic modulus of the organic insulating film are >1 GPa and >10 GPa, respectively.

### CITATION LIST

### PATENT LITERATURE

Patent Document 1: JP 2004-205685 A
Patent Document 2: JP 2017-119670 A
Patent Document 3: JP H11-512430 A
Patent Document 4: JP 2005-041938 A
Patent Document 5: JP 2009-206447 A
Patent Document 6: JP 2010-181605 A
Patent Document 7: JP 2012-215842 A
Patent Document 8: WO 2014/208324 A1
Patent Document 9: JP 2016-044272 A
Patent Document 10: JP 2016-060886 A
Patent Document 11: JP 2017-014193 A
Patent Document 12: JP 2017-119671 A
Patent Document 13: JP 2018-092170 A
Patent Document 14: WO 2019/098109 A1
Patent Document 15: JP 2005 041938 A

### SUMMARY OF INVENTION

### TECHNICAL PROBLEM

The present invention has been made in view of the above circumstances. An object of the present invention is to provide: a material for forming an organic film which is not only capable of forming an organic film excellent in planarizing property and film formability even on a substrate to be processed that has a portion that makes particularly planarization difficult, such as wide trench structure (wide trench), in a fine patterning process by a multilayer resist method in a semiconductor-device manufacturing process, and which is also capable of withstanding high-temperature heating in forming an inorganic hard mask middle layer film by a CVD method. Further, the present invention also provides a substrate for manufacturing a semiconductor device, a method for forming an organic film, and a patterning process which use the material.

### SOLUTION TO PROBLEM

To achieve the object, the present invention provides a material for forming an organic film, comprising:
(A) a compound for forming an organic film shown by the following general formula (1A); and
(B) an organic solvent, 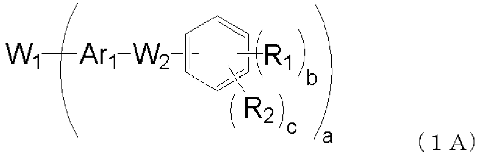 wherein Ar₁ represents a benzene ring or naphthalene ring optionally having a substituent; W₁ represents a hydrocarbon group having 1 to 15 carbon atoms optionally substituted with a fluorine atom; W₂ represents -O- or - NR₃-; each R₁ independently represents a group shown in the following formula (1B); each R₂ independently represents a halogen atom, a cyano group, or a nitro group; R₃ represents a hydrogen atom or an alkyl group having 1 to 6 carbon atoms; a=2 to 4, b=1 to 4, and c=1 to 4, with b+c≤5, 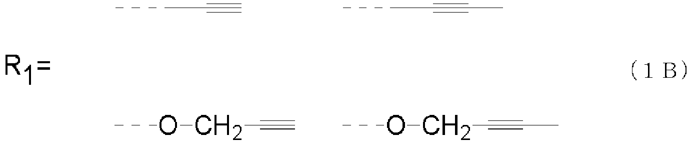
wherein a broken line represents a bonding arm.

The material for forming an organic film contains a compound which has all of a hydrocarbon group having 1 to 15 carbon atoms optionally substituted with a fluorine atom as W₁, a diaryl ether structure or diaryl amine structure, and a structure with an electron-attracting group bonded on a benzene ring incorporating a triple bond-containing terminal group as shown in the general formula (1A). This material for forming an organic film is capable of forming an organic film having all of high heat resistance, high filling property, and high planarizing property even on a substrate to be processed which has a wide trench structure (wide trench).

Moreover, the R₂ of the component (A) is preferably a fluorine atom.

Introducing a fluorine atom at R₂ of the compound for forming an organic film as described above relieves the intermolecular interaction, so that the curing temperature is successfully increased, which enhances the thermal flow. This realizes all of heat resistance, filling property, and planarizing property, which are conflicting properties, even on a substrate to be processed which has a wide trench structure (wide trench).

Further, the W₁ of the component (A) is particularly preferably shown by the following formula (1C), 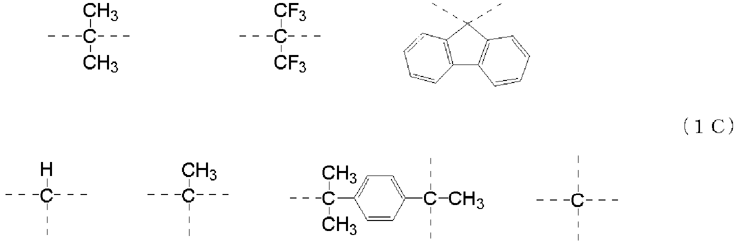 wherein a broken line represents a bonding arm.

The compound for forming an organic film having a central structure as described above can achieve all of heat resistance, filling property, and planarizing property, which are conflicting properties, even on a substrate to be processed having a wide trench structure (wide trench).

In addition, a ratio Mw/Mn of a weight-average molecular weight Mw and a number-average molecular weight Mn of the compound for forming an organic film as the component (A) in terms of polystyrene by a gel permeation chromatography method preferably satisfies 1.00≤Mw/Mn≤1.35.

Controlling the Mw/Mn of the compound for forming an organic film within such a range enables formation of an organic film excellent in filling property and planarizing property.

More preferably, the component (B) is a mixture of: one or more organic solvents each having a boiling point of lower than 180°C; and one or more organic solvents each having a boiling point of 180°C or higher.

With such a material for forming an organic film, thermal flowability is imparted to the compound for forming an organic film by the addition of a high-boiling-point solvent. Accordingly, the material for forming an organic film has both higher filling and planarizing properties.

The material for forming an organic film preferably further comprises one or more of (C) an acid generator, (D) a surfactant, (E) a crosslinking agent, and (F) a plasticizer.

The inventive material for forming an organic film may contain one or more of the components (C) to (F), depending on the purpose.

Further, the present invention provides a substrate for manufacturing a semiconductor device, comprising an organic film on the substrate, the organic film being a cured film of the above-described material for forming an organic film.

The inventive material for forming an organic film has both high filling and planarizing properties, and thereby forms an organic film free from fine pores due to insufficient filling and free from asperity in the organic film surface due to insufficient planarization. The substrate for manufacturing a semiconductor device planarized with the inventive material for forming an organic film has an increased process margin at patterning, making it possible to manufacture semiconductor devices with high yields.

Furthermore, the present invention provides a method for forming an organic film employed in a semiconductor device manufacturing process, the method comprising:
spin-coating a substrate to be processed with the above-described material for forming an organic film; and
heating the substrate to be processed coated with the material for forming an organic film under an inert gas atmosphere at a temperature of 50°C or higher and 600°C or lower for 10 seconds to 7200 seconds to obtain a cured film.

In addition, the present invention provides a method for forming an organic film employed in a semiconductor device manufacturing process, the method comprising:
spin-coating a substrate to be processed with the above-described material for forming an organic film;
heating the substrate to be processed coated with the material for forming an organic film in air at a temperature of 50°C or higher and 300°C or lower for 5 seconds to 600 seconds to form a coating film; and
then performing a heat treatment under an inert gas atmosphere at a temperature of 200°C or higher and 600°C or lower for 10 seconds to 7200 seconds to obtain a cured film.

An organic film formed according to any of the inventive methods for forming an organic film and employed in a semiconductor device manufacturing process has high heat resistance as well as high filling and planarizing properties. The use of such an organic film in a semiconductor-device manufacturing process enables favorable semiconductor-device yield.

Additionally, the inert gas atmosphere preferably has an oxygen concentration of 1% or less.

According to such methods, even when the substrate to be processed contains a material unstable under heating conditions in an oxygen atmosphere, the substrate to be processed is not degraded. The methods are useful and make it possible to more considerably suppress mixing with a resist upper layer film by promoting the crosslinking reaction to sufficiently cure the material without generating sublimation products when the organic film is formed.

Moreover, the present invention provides a method for forming an organic film employed in a semiconductor device manufacturing process, the method comprising:
spin-coating a substrate to be processed with the above-described material for forming an organic film; and
heating the substrate to be processed coated with the material for forming an organic film in air at a temperature of 50°C or higher and 600°C or lower for 10 seconds to 7200 seconds to obtain a cured film.

An organic film formed according to the inventive method for forming an organic film and employed in a semiconductor device manufacturing process has high heat resistance as well as high filling and planarizing properties. The use of such an organic film in a semiconductor-device manufacturing process enables favorable semiconductor-device yield.

Additionally, wherein the heating is performed in air at a temperature of 50°C or higher and 600°C or lower for 10 seconds to 7200 seconds to obtain a cured film, the air preferably has an oxygen concentration of 1% or more and 21% or less.

Such a method makes it possible to more considerably suppress mixing with a resist upper layer film by promoting the crosslinking reaction when the organic film is formed. Further, appropriately adjusting the heating temperature, time, and oxygen concentration within the above ranges makes it possible to obtain an organic film that has filling, planarizing, and curing properties suitable for use.

In addition, the substrate to be processed preferably has a structure or step with a height of 30 nm or more.

The inventive methods for forming an organic film are particularly useful when a flat organic film is to be formed on such a substrate to be processed.

Moreover, the present invention provides a patterning process for forming a pattern in a substrate to be processed, comprising:
forming an organic film on the substrate to be processed by using the above-described material for forming an organic film;
forming a silicon-containing resist middle layer film on the organic film by using a silicon-containing resist middle layer film material;
forming a resist upper layer film on the silicon-containing resist middle layer film by using a photoresist composition;
forming a circuit pattern in the resist upper layer film;
transferring the pattern to the silicon-containing resist middle layer film by etching while using the resist upper layer film having the formed pattern as a mask;
transferring the pattern to the organic film by etching while using the silicon-containing resist middle layer film having the transferred pattern as a mask; and
further transferring the pattern to the substrate to be processed by etching while using the organic film having the transferred pattern as a mask.

Further, the present invention provides a patterning process for forming a pattern in a substrate to be processed, comprising:
forming an organic film on the substrate to be processed by using the above-described material for forming an organic film;
forming a silicon-containing resist middle layer film on the organic film by using a silicon-containing resist middle layer film material;
forming an organic antireflective coating on the silicon-containing resist middle layer film;
forming a resist upper layer film on the organic antireflective coating by using a photoresist composition, so that a 4-layered film structure is constructed;
forming a circuit pattern in the resist upper layer film;
transferring the pattern to the organic antireflective coating and the silicon-containing resist middle layer film by etching while using the resist upper layer film having the formed pattern as a mask;
transferring the pattern to the organic film by etching while using the silicon-containing resist middle layer film having the transferred pattern as a mask; and
further transferring the pattern to the substrate to be processed by etching while using the organic film having the transferred pattern as a mask.

Additionally, the present invention provides a patterning process for forming a pattern in a substrate to be processed, comprising:
forming an organic film on the substrate to be processed by using the above-described material for forming an organic film;
forming an inorganic hard mask middle layer film selected from a silicon oxide film, a silicon nitride film, a silicon oxynitride film, a titanium oxide film, and a titanium nitride film on the organic film;
forming a resist upper layer film on the inorganic hard mask middle layer film by using a photoresist composition;
forming a circuit pattern in the resist upper layer film;
transferring the pattern to the inorganic hard mask middle layer film by etching while using the resist upper layer film having the formed pattern as a mask;
transferring the pattern to the organic film by etching while using the inorganic hard mask middle layer film having the transferred pattern as a mask; and
further transferring the pattern to the substrate to be processed by etching while using the organic film having the transferred pattern as a mask.

Furthermore, the present invention provides a patterning process for forming a pattern in a substrate to be processed comprising:
forming an organic film on the substrate to be processed by using the above-described material for forming an organic film;
forming an inorganic hard mask middle layer film selected from a silicon oxide film, a silicon nitride film, a silicon oxynitride film, a titanium oxide film, and a titanium nitride film on the organic film;
forming an organic antireflective coating on the inorganic hard mask middle layer film;
forming a resist upper layer film on the organic antireflective coating by using a photoresist composition, so that a 4-layered film structure is constructed;
forming a circuit pattern in the resist upper layer film;
transferring the pattern to the organic antireflective coating and the inorganic hard mask middle layer film by etching while using the resist upper layer film having the formed pattern as a mask;
transferring the pattern to the organic film by etching while using the inorganic hard mask middle layer film having the transferred pattern as a mask; and
further transferring the pattern to the substrate to be processed by etching while using the organic film having the transferred pattern as a mask.

The inventive material for forming an organic film can be suitably employed in various patterning processes, such as 3-layer resist process using a silicon-containing resist middle layer film or an inorganic hard mask middle layer film, and 4-layer resist process additionally using an organic antireflective coating. In a semiconductor-device manufacturing process, a semiconductor device can be manufactured with high yield by forming a circuit pattern according to the inventive patterning processes as described above.

Additionally, the inorganic hard mask middle layer film is preferably formed by a CVD method or an ALD method.

In the inventive patterning processes, the inorganic hard mask middle layer film can be formed by such methods, for example.

Further, the circuit pattern is preferably formed by a lithography using light with a wavelength of 10 nm or more to 300 nm or less, a direct drawing with electron beam, nanoimprinting, or a combination thereof.

In addition, when the circuit pattern is formed, the circuit pattern is preferably developed by alkali development or with an organic solvent.

In the inventive patterning processes, such circuit pattern formation means and development means can be suitably used.

Moreover, the substrate to be processed is preferably a semiconductor device substrate or the semiconductor device substrate coated with any of a metal film, a metal carbide film, a metal oxide film, a metal nitride film, a metal oxycarbide film, and a metal oxynitride film.

Further, a metal of the substrate to be processed preferably comprises silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

The inventive patterning processes are capable of forming a pattern by processing substrates to be processed as described above.

### ADVANTAGEOUS EFFECTS OF INVENTION

As described above, the compound for forming an organic film which the inventive material for forming an organic film contains is a useful compound for forming an organic film having all of high filling property, planarizing property, heat resistance, etching resistance, and film formability even on a substrate to be processed with a portion that makes particularly planarization difficult, such as wide trench structure (wide trench), in a fine patterning process according to a multilayer resist method in a semiconductor-device manufacturing process. Moreover, the inventive material containing this compound for forming an organic film is a material which forms an organic film having excellent filling and planarizing properties as well as various properties, such as heat resistance, etching resistance, and film formability. Accordingly, the inventive material for forming an organic film is quite useful, for example, as an organic film material in multilayer resist methods, such as 2-layer resist method, 3-layer resist method using a silicon-containing resist middle layer film, and 4-layer resist method using a silicon-containing resist middle layer film and an organic antireflective coating, or as a planarizing material for manufacturing a semiconductor device. Moreover, since an organic film formed from the inventive material for forming an organic film is excellent in heat resistance, no film thickness fluctuation is caused by thermal decomposition even when a CVD hard mask middle layer film is formed on this organic film. The organic film is suitable for patterning.

### BRIEF DESCRIPTION OF DRAWINGS

FIG. 1 is an explanatory diagram for explaining the planarizing property in the present invention.
FIG. 2 is an explanatory diagram of an example of an inventive patterning process according to a three-layer resist method.
FIG. 3 is an explanatory diagram of a method for evaluating the filling property in Examples.
FIG. 4 is an explanatory diagram of a method for evaluating the planarizing property in Examples.

### DESCRIPTION OF EMBODIMENTS

As noted above, there have been demands for the development of: a material for forming an organic film which is not only capable of forming an organic film having favorable dry etching resistance for processing a substrate, but also excellent in filling and planarizing properties for a pattern formed on a substrate including a substrate to be processed with a portion that makes particularly planarization difficult, such as wide trench structure (wide trench), in a fine patterning process according to a multilayer resist method in a semiconductor-device manufacturing process, and which does not result in film thickness fluctuation of the organic film due to thermal decomposition even when a CVD hard mask middle layer film is formed on the organic film; and a compound for forming an organic film which is used in the material and useful in a patterning process.

Generally, an organic film is formed as follows. A material for forming an organic film is prepared by dissolving a compound for forming an organic film in an organic solvent. Then, a substrate on which a structure, wiring, and so forth of a semiconductor device have been formed is coated with this material and baked to form an organic film. Immediately after the application of the material for forming an organic film, a coating film is formed along the shape of a step structure on the substrate. Nevertheless, when the coating film is baked, most of the organic solvent is evaporated before curing, so that the organic film is formed from the compound (compound for forming an organic film) remaining on the substrate. The present inventors have considered that if the compound for forming an organic film remaining on the substrate has sufficient thermal flowability, the step profile immediately after the application is planarized by thermal flow, and a flat film can be formed.

As a result of further earnest studies, the present inventors have found the following. Specifically, a compound for forming an organic film shown by the general formula (1A) has thermosetting property equivalent to those of conventional organic film materials not only in air but also under inert gas atmosphere because of the action of a substituent represented by R₁. Moreover, having all of a hydrocarbon group having 1 to 15 carbon atoms optionally substituted with a fluorine atom as W₁, a diaryl ether structure or diaryl amine structure, and a structure with an electron-attracting group bonded on a benzene ring with a triple bond-containing terminal group imparts thermal flowability and high filling and planarizing properties. The resulting material for forming an organic film also has such heat resistance that the resulting coating film has no thickness fluctuation due to thermal decomposition even when a CVD hard mask middle layer film is formed. These findings have led to the completion of the present invention.

Specifically, the present invention is a material for forming an organic film, the material comprising:
(A) a compound for forming an organic film shown by the following general formula (1A); and
(B) an organic solvent, 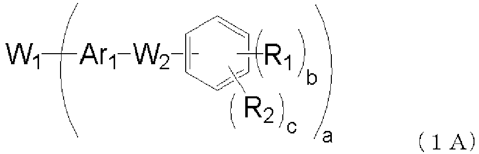 wherein Ar₁ represents a benzene ring or naphthalene ring optionally having a substituent; W₁ represents a hydrocarbon group having 1 to 15 carbon atoms optionally substituted with a fluorine atom; W₂ represents -O- or - NR₃-; each R₁ independently represents a group shown in the following formula (1B); each R₂ independently represents a halogen atom, a cyano group, or a nitro group; R₃ represents a hydrogen atom or an alkyl group having 1 to 6 carbon atoms; a=2 to 4, b=1 to 4, and c=1 to 4, with b+c≤5, 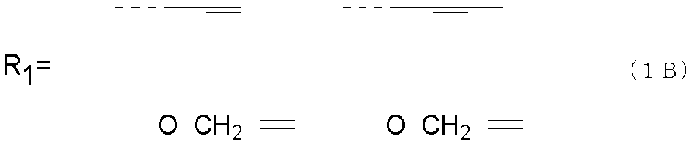 wherein a broken line represents a bonding arm.

Hereinafter, the present invention will be described in detail, but the present invention is not limited thereto but defined in the claims.

### <Compound for Forming Organic Film>

The inventive material for forming an organic film (hereinafter, may also be referred to as "organic film material") contains a compound for forming an organic film (hereinafter, may also be referred to as "organic film compound"), and this compound for forming an organic film is shown by the following general formula (1A). 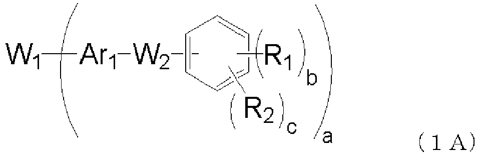 In the general formula (1A), Ar₁ represents a benzene ring or naphthalene ring optionally having a substituent. W₁ represents a hydrocarbon group having 1 to 15 carbon atoms optionally substituted with a fluorine atom. W₂ represents -O- or -NR₃-. Each R₁ independently represents a group shown in the following formula (1B). Each R₂ independently represents a halogen atom, a cyano group, or a nitro group. R₃ represents a hydrogen atom or an alkyl group having 1 to 6 carbon atoms. a=2 to 4, b=1 to 4, and c=1 to 4, with b+c≤5. 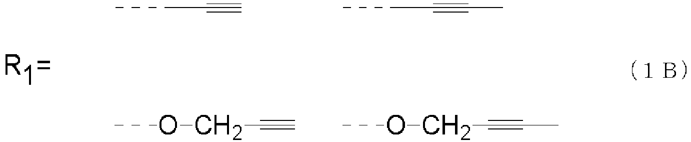 In the formula (1B), a broken line represents a bonding arm.

In the general formula (1A), W₁ is a hydrocarbon group having 1 to 15 carbon atoms optionally substituted with a fluorine atom. Ar₁ is a benzene or naphthalene ring optionally having a substituent. W₂ is -O- or -NR₃-, so that the compound has a diaryl ether structure or diaryl amine structure. R₂'s each independently represent a halogen atom, a cyano group, or a nitro group, and have an electron-attracting group on the benzene ring to which the substituent represented by R₁ is bonded as a crosslinking group.

A compound as shown by the general formula (1A) has all of: a hydrocarbon group having 1 to 15 carbon atoms optionally substituted with a fluorine atom as W₁; a diaryl ether structure or diaryl amine structure; and a structure in which an electron-attracting group is bonded on the benzene ring with a triple bond-containing terminal group. Such a compound is excellent in planarizing property and heat resistance even on a substrate to be processed having wide trench structure (wide trench), and it is possible to impart curability in air and inert gas atmosphere owing to the action of the substituent represented by R₁. Thus, an organic film formed using the organic film compound contained in the inventive material for forming an organic film makes it possible to prevent film peeling which would be otherwise caused by defect generated due to insufficient heat resistance of an organic film when an inorganic hard mask middle layer film is formed on the organic film by a CVD or ALD method.

Examples of W₁ in the general formula (1A) can include, but are not limited to, the following etc. Among these, groups having an aromatic ring may have a substituent on the aromatic ring. Examples of the substituent can include an alkyl group having 1 to 10 carbon atoms, an alkynyl group and alkenyl group having 3 to 10 carbon atoms, an aryl group having 6 to 10 carbon atoms, a nitro group, a halogen atom, a nitrile group, an alkoxycarbonyl group having 1 to 10 carbon atoms, an alkanoyloxy group having 1 to 10 carbon atoms, etc.

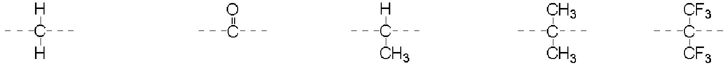

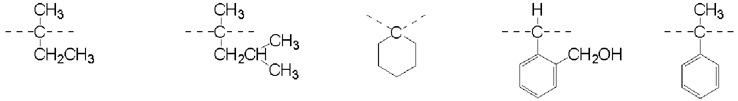

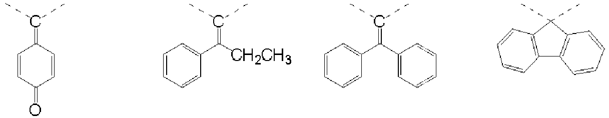

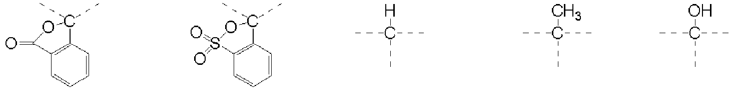

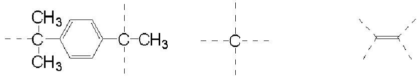

The organic film compound contained in the inventive material for forming an organic film is preferably such that the R₂ of the component (A) is a fluorine atom.

With a fluorine atom at R₂ in the component (A), the intermolecular interaction is relieved, which enables high curing temperature, thereby enhancing the thermal flow. This realizes all of heat resistance, filling property, and planarizing property, which are conflicting properties, even on a substrate to be processed having wide trench structure (wide trench).

Further, the organic film compound contained in the inventive material for forming an organic film is particularly preferably such that the W₁ of the component (A) is shown by the following formula (1C).

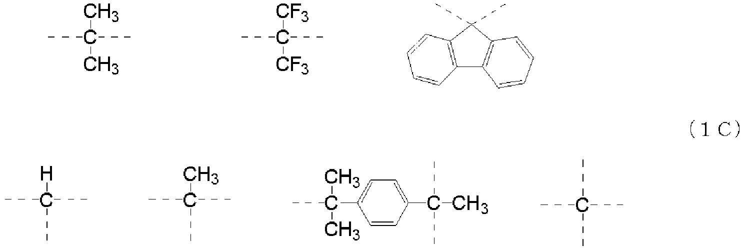

The organic film compound having such a central structure as described above can achieve all of heat resistance, filling property, and planarizing property, which are conflicting properties, even on a substrate to be processed having wide trench structure (wide trench).

The organic film compound contained in the inventive material for forming an organic film preferably satisfies 1.00≤Mw/Mn≤1.35, where Mw/Mn is a ratio of a weight-average molecular weight Mw and a number-average molecular weight Mn of the compound for forming an organic film as the component (A) determined in terms of polystyrene by a gel permeation chromatography method. By definition, the Mw/Mn of monomer compounds is 1.00, but the measurement values exceed 1.00 in some cases due to separability in GPC. Unless a special polymerization method is employed, polymers having repeating units are generally quite difficult to have Mw/Mn close to 1.00, and the Mw distribution of the polymers is such that the Mw/Mn value exceeds 1. In the present invention, 1.00≤Mw/Mn≤1.35 is defined as an indicator indicating monomeric nature to distinguish between monomer compounds and polymers.

By controlling the Mw/Mn of the organic film compound within such a range, it is possible to form an organic film excellent in filling and planarizing properties.

With the Mw/Mn within the above range, the compound for forming an organic film has further favorable thermal flowability. Thus, when the compound is blended in a material for forming an organic film, the formed organic film can not only favorably fill a fine structure formed on a substrate, but also planarize the entire substrate.

### [Method for Producing Compound for Forming Organic Film] (1) In the case where W₂ is -O-

As a means for obtaining the organic film compound contained in the inventive material for forming an organic film, it is possible to synthesize the compound, for example, by substitution reaction of a phenol or naphthol with a valency of "a" and a fluorobenzene having the substituents R₁ and R₂ as shown below with a base catalyst. One kind of each of the phenol or naphthol with a valency of "a" and the fluorobenzene having the substituents R₁ and R₂ can be used for the synthesis, or two or more kinds thereof may be used. These can be appropriately selected and combined according to required properties. In the following formula, Ar₁, W₁, R₁, R₂, "a", "b", and "c" are as defined above.

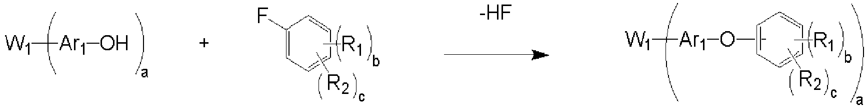

Examples of the base catalyst used in this event include inorganic base compounds, such as sodium hydrogen carbonate, sodium carbonate, potassium carbonate, calcium carbonate, cesium carbonate, sodium hydroxide, potassium hydroxide, sodium hydride, and potassium phosphate; organic amine compounds, such as triethylamine, pyridine, and N-methylmorpholine; etc. One of these or a combination of two or more thereof can be used. The amount of these catalysts used is within a range of preferably 0.1 to 20 moles, more preferably 0.2 to 10 moles, per mol of hydroxyl groups of the raw-material phenol or naphthol with a valency of "a".

The solvent used in this event is not particularly limited, as long as the solvent is inactive in the reaction. Examples of the solvent include ether-based solvents, such as diethyl ether, tetrahydrofuran, and dioxane; aromatic solvents, such as benzene, toluene, and xylene; acetonitrile, dimethylsulfoxide, N,N-dimethylformamide, N-methylpyrrolidone, water, etc. One of these or a mixture thereof can be used. These solvents can be used within a range of 0 to 2,000 parts by mass relative to 100 parts by mass of the reaction raw materials. The reaction temperature is preferably - 50°C to approximately the boiling point of the solvent, further preferably room temperature to 150°C. The reaction time is appropriately selected from 0.1 to 100 hours.

The reaction method includes: a method in which the phenol or naphthol and the fluorobenzene are charged into a solvent at once; a method in which each or a mixture of the phenol or naphthol and the fluorobenzene is prepared into a form of dispersion or solution and charged dropwise; a method in which one of the phenol or naphthol and the fluorobenzene is dispersed or dissolved in a solvent, and then the other dispersed or dissolved in a solvent is charged dropwise therein; and the like. Furthermore, when multiple kinds of the phenol or naphthol and the fluorobenzene are charged, they can be mixed for reaction beforehand, or they can be made to react individually in succession. Examples of the method with a base catalyst include: a method in which the base catalyst is charged at once with the phenol or naphthol and the fluorobenzene; a method in which the base catalyst prepared in a form of dispersion or solution beforehand is then added dropwise; and the like.

### (2) In the case where W₂ is -NR₃-

As a means for obtaining the organic film compound contained in the inventive material for forming an organic film, it is possible to synthesize the compound, for example, by substitution reaction of an aniline or naphthylamine with a valency of "a" and a fluorobenzene having the substituents R₁ and R₂ as shown below with a base catalyst. One kind of each of the aniline or naphthylamine with a valency of "a" and the fluorobenzene having the substituents R₁ and R₂ can be used for the synthesis, or two or more kinds thereof may be used. These can be appropriately selected and combined according to required properties. In the following formula, Ar₁, W₁, R₁, R₂, R₃, "a", "b", and "c" are as defined above.

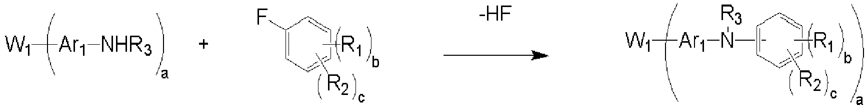

Examples of the base catalyst used in this event include inorganic base compounds, such as sodium hydrogen carbonate, sodium carbonate, potassium carbonate, calcium carbonate, cesium carbonate, sodium hydroxide, potassium hydroxide, sodium hydride, and potassium phosphate; organic amine compounds, such as triethylamine, pyridine, and N-methylmorpholine; etc. One of these or a combination of two or more thereof can be used. The amount of these catalysts used is within a range of preferably 0.1 to 20 moles, more preferably 0.2 to 10 moles, per mol of amino groups of the raw-material aniline or naphthylamine with a valency of "a".

The solvent used in this event is not particularly limited, as long as the solvent is inactive in the reaction. Examples of the solvent include ether-based solvents, such as diethyl ether, tetrahydrofuran, and dioxane; aromatic solvents, such as benzene, toluene, and xylene; acetonitrile, dimethylsulfoxide, N,N-dimethylformamide, N-methylpyrrolidone, water, etc. One of these or a mixture thereof can be used. These solvents can be used within a range of 0 to 2,000 parts by mass relative to 100 parts by mass of the reaction raw materials. The reaction temperature is preferably - 50°C to approximately the boiling point of the solvent, further preferably room temperature to 150°C. The reaction time is appropriately selected from 0.1 to 100 hours.

The reaction method includes: a method in which the aniline or naphthylamine and the fluorobenzene are charged into a solvent at once; a method in which each or a mixture of the aniline or naphthylamine and the fluorobenzene is prepared into a form of dispersion or solution and charged dropwise; a method in which one of the aniline or naphthylamine and the fluorobenzene is dispersed or dissolved in a solvent, and then the other dispersed or dissolved in a solvent is charged dropwise therein; and the like. Furthermore, when multiple kinds of the aniline or naphthylamine and the fluorobenzene are charged, they can be mixed for reaction beforehand, or they can be made to react individually in succession. Examples of the method with a base catalyst include: a method in which the base catalyst is charged at once with the aniline or naphthylamine and the fluorobenzene; a method in which the base catalyst prepared in a form of dispersion or solution beforehand is then added dropwise; and the like.

In either case where W₂ is -O- or -NR₃-, the obtained reaction solution may be diluted with an organic solvent, then subjected to liquid-liquid separation and washing to remove unreacted raw materials, the catalyst, and so on present in the system, and thus collected.

The organic solvent used in the liquid-liquid separation and washing is not particularly limited, as long as the organic solvent is capable of dissolving the compounds and is separated into two layers when mixed with water. The organic solvent includes hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-tert-butyl ether, and ethylcyclopentylmethyl ether; chlorinated solvents, such as methylene chloride, chloroform, dichloroethane, and trichloroethylene; mixtures thereof; etc. As washing water used in this event, generally, what is called deionized water or ultrapure water may be used. The washing may be performed one or more times, preferably approximately one to five times because washing ten times or more does not always produce the full washing effects thereof.

In the liquid-liquid separation and washing, the washing may be performed with a basic aqueous solution to remove the unreacted raw materials or acidic components in the system. The base specifically includes hydroxides of alkaline metals, carbonates of alkaline metals, hydroxides of alkali earth metals, carbonates of alkali earth metals, ammonia, organic ammonium, etc.

Further, in the liquid-liquid separation and washing, the washing may be performed with an acidic aqueous solution to remove the unreacted raw materials, metal impurities, or basic components in the system. The acid specifically includes inorganic acids, such as hydrochloric acid, hydrobromic acid, sulfuric acid, nitric acid, phosphoric acid, and heteropoly acid; organic acids, such as oxalic acid, fumaric acid, maleic acid, trifluoroacetic acid, methanesulfonic acid, benzenesulfonic acid, p-toluenesulfonic acid, and trifluoromethanesulfonic acid; etc.

The liquid-liquid separation and washing may be performed with any one of the basic aqueous solution and the acidic aqueous solution, or can be performed with a combination of the two. The liquid-liquid separation and washing is preferably performed with the basic aqueous solution and the acidic aqueous solution in this order from the viewpoint of removing the metal impurities.

After the liquid-liquid separation and washing with the basic aqueous solution and the acidic aqueous solution, washing with neutral water may be successively performed. As the neutral water, deionized water, ultrapure water, or the like as mentioned above may be used. The washing may be performed one or more times, but if the washing is not performed sufficiently, the basic components and acidic components cannot be removed in some cases. The washing is preferably performed approximately one to five times because washing ten times or more does not always produce the full washing effects thereof.

Further, the reaction product after the liquid-liquid separation can also be collected as a powder by concentrating and drying the solvent or crystallizing the reaction product under reduced pressure or normal pressure. Alternatively, the reaction product can also be retained in the state of solution with an appropriate concentration to improve the workability in preparing the material for forming an organic film. The concentration in this event is preferably 0.1 to 50 mass%, more preferably 0.5 to 30 mass%. With such a concentration, the viscosity is hardly increased, making it possible to prevent deterioration of the workability; in addition, since the amount of the solvent is not excessive, it is economical.

The solvent in this event is not particularly limited, as long as the solvent is capable of dissolving the compound. Specific examples of the solvent include ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One of these or a mixture of two or more thereof can be used.

In the above reaction, the fluorobenzene can be combined with the phenol, naphthol, aniline, or naphthylamine according to a performance requirement. Specifically, it is possible to introduce and use, for example, a substituent that contributes to solvent solubility, adhesiveness, curability, filling and planarizing properties, etching resistance, and film formability according to a desired performance requirement. An organic film material using these compounds can achieve all of higher filling and planarizing properties as well as higher heat resistance.

As described above, the organic film compound contained in the inventive material for forming an organic film enables the material for forming an organic film to have all of heat resistance to 400°C or higher and high filling and planarizing properties even on a substrate to be processed having wide trench structure (wide trench).

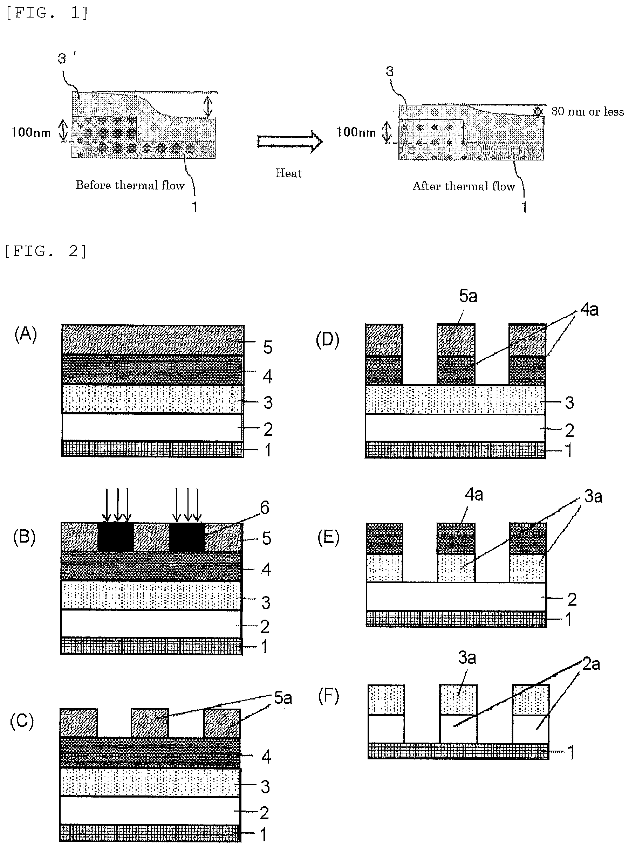

Note that, in the present invention, the term planarizing property refers to a performance of planarizing the surface of a substrate. For example, as shown in FIG. 1, the inventive material containing the compound for forming an organic film can reduce a 100-nm step of a substrate 1 to 30 nm or less by coating the substrate 1 with a material 3' for forming an organic film and heating the resultant to form an organic film 3. Note that the step profile shown in FIG. 1 represents a typical example of the step profile in a substrate for manufacturing a semiconductor device. It is a matter of course that the step profile of a substrate which can be planarized by the inventive material containing the compound for forming an organic film is not limited thereto.

### <Material for Forming Organic Film>

Further, the present invention provides a material for forming an organic film (composition for forming an organic film), containing: (A) the organic film compound shown by the general formula (1A); and (B) an organic solvent. Note that in the inventive material for forming an organic film, one kind of the above-described compound for forming an organic film or a combination of two or more kinds thereof can be used.

### [(B) Organic Solvent]

The organic solvent that can be used in the inventive material for forming an organic film is not particularly limited as long as the solvent can dissolve the compound and other components contained in the material, such as additives. Specifically, solvents with a boiling point of lower than 180°C can be used, such as those disclosed in paragraphs [0091] and [0092] of JP 2007-199653 A. Above all, propylene glycol monomethyl ether acetate, propylene glycol monomethyl ether, 2-heptanone, cyclopentanone, cyclohexanone, and a mixture of two or more thereof are preferably used. The organic solvent is blended in an amount of preferably 200 to 10,000 parts, more preferably 300 to 5,000 parts, based on 100 parts of the compound (A).

Such a material for forming an organic film can be applied by spin-coating, and has all of heat resistance to 400°C or higher and high filling and planarizing properties even on a substrate to be processed having wide trench structure (wide trench) because the compound for forming an organic film as described above is incorporated.

Further, the inventive material for forming an organic film may use the organic solvent in which a high-boiling-point solvent having a boiling point of 180°C or higher is added to the aforementioned solvent having a boiling point of lower than 180°C. In other words, the component (B) may be a mixture of: one or more organic solvents each having a boiling point of lower than 180°C; and one or more organic solvents each having a boiling point of 180°C or higher. The high-boiling-point solvent is not particularly limited to hydrocarbons, alcohols, ketones, esters, ethers, chlorinated solvents, and so forth as long as the high-boiling-point solvent is capable of dissolving the compound for forming an organic film. Specific examples of the high-boiling-point organic solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butylmethyl ether, triethylene glycol dimethyl ether, triethylene glycol monomethyl ether, triethylene glycol-n-butyl ether, triethylene glycol butylmethyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, dihexyl malonate, diethyl succinate, dipropyl succinate, dibutyl succinate, dihexyl succinate, dimethyl adipate, diethyl adipate, dibutyl adipate, and the like. One of these or a mixture thereof may be used.

The boiling point of the high-boiling-point solvent may be appropriately selected according to the temperature at which the material for forming an organic film is heated. The boiling point of the high-boiling-point solvent to be added is preferably 180°C to 300°C, more preferably 200°C to 300°C. Such a boiling point prevents the evaporation rate at baking (heating) from becoming excessive. Thus, sufficient thermal flowability can be achieved. Meanwhile, with such a boiling point, the high-boiling-point solvent evaporates after baking and does not remain in the film; thus, the boiling point in these ranges does not adversely affect the film physical properties, such as etching resistance.

When the high-boiling-point solvent is used, the formulation amount of the high-boiling-point solvent is preferably 1 to 30 parts by mass based on 100 parts by mass of the solvent having a boiling point of lower than 180°C. The formulation amount in this range can impart sufficient thermal flowability during baking, the high-boiling-point solvent does not remain in the film, and deterioration of the film physical properties such as etching resistance is prevented.

With such a material for forming an organic film, the above-described compound for forming an organic film is provided with thermal flowability by adding the high-boiling-point solvent, so that the material for forming an organic film has both high filling and planarizing properties.

### [(C) Acid Generator]

The inventive material for forming an organic film can contain (C) an acid generator so as to further promote the curing reaction. The acid generator includes a material that generates an acid by thermal decomposition, and a material that generates an acid by light irradiation. Any of these can be incorporated. Specifically, acid generators disclosed in paragraphs [0061] to [0085] of JP 2007-199653 A can be incorporated, but the present invention is not limited thereto but defined in the claims.

One kind of the acid generator can be used singly, or two or more kinds thereof can be used in combination. When added, the acid generator is added in an amount of preferably 0.05 to 50 parts, more preferably 0.1 to 10 parts, based on 100 parts of the compound.

### [(D) Surfactant]

The inventive material for forming an organic film can contain (D) a surfactant so as to enhance the coating property in spin coating. As the surfactant, for example, those disclosed in [0142] to [0147] of JP 2009-269953 A can be used. When contained, the surfactant is contained in an amount of preferably 0.01 to 10 parts, more preferably 0.05 to 5 parts, based on 100 parts of the compound.

### [(E) Crosslinking Agent]

Moreover, the inventive material for forming an organic film can also contain a crosslinking agent (E) so as to increase the curability and to further suppress intermixing with a resist upper layer film. The crosslinking agent is not particularly limited, and known various types of crosslinking agents can be widely used. Examples thereof can include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, and epoxy-based crosslinking agents.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

A specific example of the β-hydroxyalkylamide-based crosslinking agents includes N,N,N',N'-tetra(2-hydroxyethyl) adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylenebis-4,5-diphenyl-2-oxazoline, 2,2'-methylenebis-4-phenyl-2-oxazoline, 2,2'-methylenebis-4-tert-butyl-2-oxazoline, 2,2'-bis(2-oxazoline), 1,3-phenylenebis(2-oxazoline), 1,4-phenylenebis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

When contained, the crosslinking agent is contained in an amount of preferably 1 to 100 parts, more preferably 5 to 50 parts, based on 100 parts of the compound.

### [(F) Plasticizer]

Further, the inventive material for forming an organic film can contain (F) a plasticizer so as to further enhance planarizing and filling properties. The plasticizer is not particularly limited, and known various types of plasticizers can be widely used. Examples thereof can include low-molecular-weight compounds, such as phthalic acid esters, adipic acid esters, phosphoric acid esters, trimellitic acid esters, and citric acid esters; and polymers, such as polyethers, polyesters, and polyacetal-based polymers disclosed in JP 2013-253227 A. When contained, the plasticizer is contained in an amount of preferably 1 to 100 parts, more preferably 5 to 30 parts, based on 100 parts of the compound.

### [Additives]

Moreover, to the inventive material for forming an organic film, an additive may be added so as to impart filling and planarizing properties like the plasticizer. As the additive, for example, it is preferable to use liquid additives having polyethylene glycol or polypropylene glycol structures, or thermo-decomposable polymers having a weight loss ratio of 40 mass% or more between 30°C and 250°C and a weight-average molecular weight of 300 to 200,000. The thermo-decomposable polymers preferably contain a repeating unit having an acetal structure shown by the following general formula (DP1) or (DP1a). When contained, these additives are contained in an amount of preferably 1 to 100 parts, more preferably 5 to 50 parts, based on 100 parts of the compound. 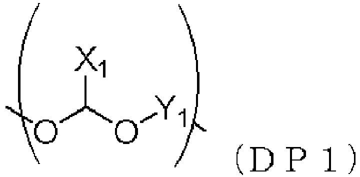 In the general formula (DP1), X₁ represents a hydrogen atom or a saturated or unsaturated monovalent organic group having 1 to 30 carbon atoms optionally having a substituent. Y₁ represents a saturated or unsaturated divalent organic group having 2 to 30 carbon atoms. 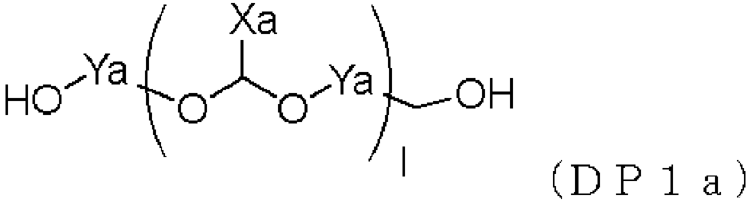 In the general formula (DP1a), Xₐ represents an alkyl group having 1 to 4 carbon atoms. Yₐ represents a saturated or unsaturated divalent hydrocarbon group having 4 to 10 carbon atoms optionally having an ether bond. "l" represents an integer of 3 to 500 as an average repeating unit number.

As described above, the inventive material for forming an organic film has all of heat resistance to 400°C or higher and high filling and planarizing properties even on a substrate to be processed having wide trench structure (wide trench). Thus, the inventive material for forming an organic film is quite useful as a material for forming an organic film in multilayer resist methods, such as a two-layer resist method, a three-layer resist method using a silicon-containing resist middle layer film or inorganic hard mask middle layer film, and a four-layer resist method using a silicon-containing resist middle layer film or inorganic hard mask middle layer film and an organic antireflective coating. Moreover, the inventive material for forming an organic film generates no byproduct even during film formation in an inert gas atmosphere, and has excellent filling and planarizing properties. Accordingly, the inventive material for forming an organic film can also be suitably used as a planarizing material in a semiconductor device manufacturing process, besides the multilayer resist methods.

### <Substrate for Manufacturing Semiconductor Device>

Additionally, the present invention provides a substrate for manufacturing a semiconductor device, the substrate including an organic film formed on the substrate, the organic film being formed by curing the above-described material for forming an organic film.

An organic film formed from the inventive material for forming an organic film has both high filling and planarizing properties, and is therefore an organic film free from fine pores due to insufficient filling and free from asperity in the organic film surface due to insufficient planarizing. Thus, a semiconductor device substrate planarized with such an organic film has an increased process margin at patterning, making it possible to manufacture semiconductor devices with high yields.

### <Methods for Forming Organic Film>

The present invention provides a method for forming an organic film employed in a semiconductor device manufacturing process, the method including:
spin-coating a substrate to be processed with the above-described material for forming an organic film; and
heating the substrate to be processed coated with the material for forming an organic film under an inert gas atmosphere at a temperature of 50°C or higher and 600°C or lower for 10 seconds to 7200 seconds to obtain a cured film (one-stage baking).

Moreover, the present invention provides a method for forming an organic film employed in a semiconductor device manufacturing process, the method including:
spin-coating a substrate to be processed with the above-described material for forming an organic film;
heating the substrate to be processed coated with the material for forming an organic film in air at a temperature of 50°C or higher and 300°C or lower for 5 seconds to 600 seconds to form a coating film; and
then performing a heat treatment under an inert gas atmosphere at a temperature of 200°C or higher and 600°C or lower, preferably at a temperature of 250°C or higher, for 10 seconds to 7200 seconds to obtain a cured film (two-stage baking).

In these methods for forming an organic film, first, a substrate to be processed is spin-coated with the above-described inventive material for forming an organic film. By employing the spin-coating method, favorable filling property can be obtained. After the spin-coating, baking (heating) is performed to promote the planarization attributable to thermal flow and the crosslinking reaction. Note that since this baking allows the organic solvent in the material for forming an organic film to evaporate, even when a resist upper layer film or a silicon-containing resist middle layer film is formed on the organic film, the mixing thereof can be prevented.

The film formation step by heating to form an organic film (organic underlayer film) can employ one-stage baking, two-stage baking, or multi-stage baking of three or more stages. Nevertheless, one-stage baking or two-stage baking is economically preferable.

The film formation by the one-stage baking is performed under an inert gas atmosphere at a temperature of 50°C or higher to 600°C or lower for 10 to 7200 seconds, preferably at a temperature of 150°C or higher to 500°C or lower for 10 to 3600 seconds. Heating under such conditions can promote the planarization attributable to thermal flow and the crosslinking reaction.

In a multilayer resist method, a coating-type silicon-containing resist middle layer film or a CVD hard mask middle layer film is sometimes formed on a film thus obtained. In the case where a coating-type silicon-containing resist middle layer film is employed, the organic film is formed preferably at a temperature higher than a temperature at which the silicon-containing resist middle layer film is formed. Generally, a silicon-containing resist middle layer film is formed at 100°C or higher to 400°C or lower, preferably 150°C or higher to 350°C or lower. Forming the organic film at a temperature higher than these temperatures makes it possible to prevent a composition for forming the silicon-containing resist middle layer film from dissolving the organic film, and to prevent the formed organic film from mixing with the composition. In the case where a CVD hard mask middle layer film is employed in the one-stage baking, the organic film is formed preferably at a temperature higher than a temperature at which the CVD hard mask middle layer film is formed. Examples of the temperature at which the CVD hard mask middle layer film is formed include temperatures at 150°C or higher to 500°C or lower.

On the other hand, in film formation by the two-stage baking, the first baking is performed in air at the treatment temperature of 50°C or higher to 300°C or lower, preferably 250°C or lower, for 5 to 600 seconds, considering the influence of substrate corrosion due to oxygen in air. The second baking is performed under an inert gas atmosphere, and the baking temperature is higher than the first baking temperature. The second baking is performed at a temperature of 200°C or higher to 600°C or lower, preferably 250°C or higher to 500°C or lower, for 10 to 7200 seconds.

In a multilayer resist method, a coating-type silicon-containing resist middle layer film or a CVD hard mask middle layer film is sometimes formed on a film thus obtained. In the case where a coating-type silicon-containing resist middle layer film is employed, the organic film is formed preferably at a temperature higher than a temperature at which the silicon-containing resist middle layer film is formed. Generally, a silicon-containing resist middle layer film is formed at 100°C or higher to 400°C or lower, preferably 150°C or higher to 350°C or lower. Forming the organic film at a temperature higher than these temperatures makes it possible to prevent a composition for forming the silicon-containing resist middle layer film from dissolving the organic film, and to form an organic film not mixed with the composition. In the case where a CVD hard mask middle layer film is employed in the two-stage baking, the organic film is formed preferably at a temperature higher than a temperature at which the CVD hard mask middle layer film is formed. Examples of the temperature at which the CVD hard mask middle layer film is formed include temperatures at 150°C or higher to 500°C or lower.

Additionally, the present invention provides a method for forming an organic film that functions as an organic underlayer film used in a semiconductor device manufacturing process, where a cured film is formed by heating a substrate to be processed in an atmosphere with an oxygen concentration of 1% or less to prevent corrosion of the substrate to be processed. Specifically, the present invention provides a method for forming an organic film, where the inert gas atmosphere has an oxygen concentration of 1% or less.

In this method for forming an organic film, first of all, a substrate to be processed is spin-coated with the above-described inventive material for forming an organic film. After the spin-coating, in the two-stage baking, first, the first baking is performed in air at 300°C or lower. Then, the second baking is performed under an atmosphere with an oxygen concentration of 1% or less. In the one-stage baking, the first baking in air can be skipped. Note that examples of the atmosphere during the baking include such inert gases as nitrogen, argon, and helium. The inventive material for forming an organic film is capable of forming a sufficiently cured organic film without generating a sublimation product, even when the baking is performed under such an inert gas atmosphere.

Further, the present invention provides a method for forming an organic film employed in a semiconductor device manufacturing process, the method including:
spin-coating a substrate to be processed with the above-described material for forming an organic film; and
heating the substrate to be processed coated with the material for forming an organic film in air at a temperature of 50°C or higher and 600°C or lower for 10 seconds to 7200 seconds to obtain a cured film.

In this event, the air preferably has an oxygen concentration of 1% or more and 21% or less.

In this method for forming an organic film, first of all, a substrate to be processed is spin-coated with the above-described inventive material for forming an organic film. After the spin-coating, in the two-stage baking, first, the first baking is performed in air at 300°C or lower. Then, the second baking is further performed in air with an oxygen concentration of 1% or more and 21% or less. In the one-stage baking, the first baking in air can be skipped. The inventive material for forming an organic film is capable of forming a sufficiently cured organic film without generating a sublimation product, even the baking is performed in air with an oxygen concentration of 1% or more and 21% or less.

Moreover, the inventive methods for forming an organic film make it possible to use a substrate to be processed having a structure or a step with a height of 30 nm or more. As described above, since the inventive material for forming an organic film is excellent in filling and planarizing properties, even when the substrate to be processed has a structure or a step (asperity) with a height of 30 nm or more, a flat cured film can be formed. That is, the inventive methods for forming an organic film are particularly useful when a flat organic film is formed on such a substrate to be processed.

Note that the thickness of the organic film to be formed is appropriately selected, but is preferably 30 to 20,000 nm, particularly preferably 50 to 15,000 nm.

Additionally, the above-described methods for forming an organic film by the inventive material for forming an organic film are applicable to both cases where an organic film for an organic underlayer film is formed, and where an organic film for a flat film is formed.

### <Patterning Processes>

### [3-Layer Resist Method using Silicon-Containing Resist Middle Layer Film]

The present invention provides a patterning process for forming a pattern in a substrate to be processed, the process including:
forming an organic film on the substrate to be processed by using the above-described material for forming an organic film;
forming a silicon-containing resist middle layer film on the organic film by using a silicon-containing resist middle layer film material;
forming a resist upper layer film on the silicon-containing resist middle layer film by using a photoresist composition;
forming a circuit pattern in the resist upper layer film;
transferring the pattern to the silicon-containing resist middle layer film by etching while using the resist upper layer film having the formed pattern as a mask;
transferring the pattern to the organic film by etching while using the silicon-containing resist middle layer film having the transferred pattern as a mask; and
further transferring the pattern to the substrate to be processed by etching while using the organic film having the transferred pattern as a mask.

As the substrate to be processed, it is preferable to use a semiconductor device substrate or the semiconductor device substrate coated with any of a metal film, a metal carbide film, a metal oxide film, a metal nitride film, a metal oxycarbide film, and a metal oxynitride film. More specifically, examples of the substrate which may be used include, but are not particularly limited to: substrates made of Si, α-Si, p-Si, SiO₂, SiN, SiON, W, TiN, Al, or the like; and these substrates coated with the above-described metal film or the like as a layer to be processed.

Examples of the layer to be processed which may be used include various Low-k films made of Si, SiO₂, SiON, SiN, p-Si, α-Si, W, W-Si, Al, Cu, Al-Si, or the like, and stopper films thereof. The layer can be formed to have a thickness of generally 50 to 10,000 nm, particularly 100 to 5,000 nm. Note that when the layer to be processed is formed, the substrate and the layer to be processed are formed from different materials.

Note that it is preferable to use, as a metal of the substrate to be processed, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

Further, as the substrate to be processed, a substrate to be processed having a structure or a step with a height of 30 nm or more is preferably used.

When the organic film is formed on the substrate to be processed using the inventive material for forming an organic film, the above-described inventive methods for forming an organic film can be employed.

Next, using a resist middle layer film material containing silicon atoms, a resist middle layer film (silicon-containing resist middle layer film) is formed on the organic film. The silicon-containing resist middle layer film material is preferably a polysiloxane-based resist middle layer film material. The silicon-containing resist middle layer film having an antireflective effect can suppress the reflection. Particularly, for 193-nm light exposure, a material containing many aromatic groups and having a high etching selectivity relative to the substrate is used as a material for forming an organic film, so that the k-value and thus the substrate reflection are increased. Meanwhile, the reflection can be suppressed by imparting absorption to the silicon-containing resist middle layer film so as to have an appropriate k-value, and the substrate reflection can be reduced to 0.5% or less. As the silicon-containing resist middle layer film having an antireflective effect, a polysiloxane is preferably used which has anthracene for 248-nm and 157-nm light exposure, or a phenyl group or a light-absorbing group having a silicon-silicon bond for 193-nm light exposure in a pendant structure or a polysiloxane structure, and which is crosslinked by an acid or heat.

Next, using a resist upper layer film material composed of a photoresist composition, a resist upper layer film is formed on the silicon-containing resist middle layer film. The resist upper layer film material may be a positive type or a negative type, and any generally-used photoresist composition can be used. After the spin-coating of the resist upper layer film material, pre-baking is preferably performed at 60 to 180°C for 10 to 300 seconds. Then, light exposure, and furthermore, post-exposure bake (PEB), and development are performed according to conventional methods to obtain a resist upper layer film pattern. Note that the thickness of the resist upper layer film is not particularly limited, but is preferably 30 to 500 nm, particularly preferably 50 to 400 nm.

Next, a circuit pattern (the resist upper layer film pattern) is formed in the resist upper layer film. The circuit pattern is preferably formed by a lithography using light with a wavelength of 10 nm or more to 300 nm or less, a direct drawing with electron beam, nanoimprinting, or a combination thereof.

Note that the exposure light includes high energy beam with a wavelength of 300 nm or less; specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) with a wavelength of 3 to 20 nm, electron beam (EB), ion beam, X-ray, etc.

Furthermore, when the circuit pattern is formed, the circuit pattern is preferably developed by alkaline development or with an organic solvent.

Next, the pattern is transferred to the silicon-containing resist middle layer film by etching while using the resist upper layer film having the formed circuit pattern as a mask. The etching of the silicon-containing resist middle layer film while using the resist upper layer film pattern as a mask is preferably performed with a fluorocarbon-based gas. Thereby, a silicon-containing resist middle layer film pattern is formed.

Next, the pattern is transferred to the organic film by etching while using the silicon-containing resist middle layer film having the transferred pattern as a mask. Since the silicon-containing resist middle layer film exhibits higher etching resistance to an oxygen gas or a hydrogen gas than that of an organic material, the etching of the organic film while using the silicon-containing resist middle layer film pattern as a mask is preferably performed with an etching gas mainly containing an oxygen gas or a hydrogen gas. Thereby, an organic film pattern can be formed.

Next, the pattern is transferred to the substrate to be processed by etching while using the organic film having the transferred pattern as a mask. The etching of the substrate to be processed (layer to be processed) can be performed according to a conventional method. For example, the substrate to be processed made of SiO₂, SiN, or silica low-dielectric insulating film is etched mainly with a fluorocarbon-based gas. The substrate to be processed made of p-Si, Al, or W is etched mainly with a chlorine- or bromine-based gas. When the substrate is processed by etching with a fluorocarbon-based gas, the silicon-containing resist middle layer film pattern is removed together with the substrate processing. Meanwhile, when the substrate is processed by etching with a chlorine- or bromine-based gas, the silicon-containing resist middle layer film pattern needs to be removed by additional dry-etching with a fluorocarbon-based gas after the substrate processing.

The organic film obtained using the inventive material for forming an organic film can exhibit excellent etching resistance when the substrate to be processed is etched as described above.

### [4-Layer Resist Method using Silicon-Containing Resist Middle Layer Film and Organic Antireflective Coating]

Moreover, the present invention provides a patterning process for forming a pattern in a substrate to be processed, the process including:
forming an organic film on the substrate to be processed by using the above-described material for forming an organic film;
forming a silicon-containing resist middle layer film on the organic film by using a silicon-containing resist middle layer film material;
forming an organic antireflective coating on the silicon-containing resist middle layer film;
forming a resist upper layer film on the organic antireflective coating by using a photoresist composition, so that a 4-layered film structure is constructed;
forming a circuit pattern in the resist upper layer film;
transferring the pattern to the organic antireflective coating and the silicon-containing resist middle layer film by etching while using the resist upper layer film having the formed pattern as a mask;
transferring the pattern to the organic film by etching while using the silicon-containing resist middle layer film having the transferred pattern as a mask; and
further transferring the pattern to the substrate to be processed by etching while using the organic film having the transferred pattern as a mask.

Note that this method can be performed in the same manner as the above-described three-layer resist method using the silicon-containing resist middle layer film, except that the organic antireflective coating (BARC) is formed between the silicon-containing resist middle layer film and the resist upper layer film.

The organic antireflective coating can be formed by spin-coating using a known organic antireflective coating material.

### [3-Layer Resist Method using Inorganic Hard Mask Middle Layer Film]

Further, the present invention provides a patterning process for forming a pattern in a substrate to be processed, the process including:
forming an organic film on the substrate to be processed by using the above-described material for forming an organic film;
forming an inorganic hard mask middle layer film selected from a silicon oxide film, a silicon nitride film, a silicon oxynitride film, a titanium oxide film, and a titanium nitride film on the organic film;
forming a resist upper layer film on the inorganic hard mask middle layer film by using a photoresist composition;
forming a circuit pattern in the resist upper layer film;
transferring the pattern to the inorganic hard mask middle layer film by etching while using the resist upper layer film having the formed pattern as a mask;
transferring the pattern to the organic film by etching while using the inorganic hard mask middle layer film having the transferred pattern as a mask; and
further transferring the pattern to the substrate to be processed by etching while using the organic film having the transferred pattern as a mask.

Note that this method can be performed in the same manner as the above-described three-layer resist method using the silicon-containing resist middle layer film, except that the inorganic hard mask middle layer film is formed in place of the silicon-containing resist middle layer film on the organic film.

The inorganic hard mask middle layer film selected from a silicon oxide film, a silicon nitride film, a silicon oxynitride film (SiON film), a titanium oxide film, and a titanium nitride film can be formed by a CVD method, an ALD method, etc. The inorganic hard mask middle layer film is particularly preferably formed by a CVD method or an ALD method. The method for forming the silicon nitride film is disclosed in, for example, JP 2002-334869 A, WO 2004/066377 A1, etc. The film thickness of the inorganic hard mask middle layer film is preferably 5 to 200 nm, more preferably 10 to 100 nm. As the inorganic hard mask middle layer film, a SiON film is most preferably used which is effective as an antireflective coating. When the SiON film is formed, the substrate temperature reaches 300 to 500°C. Hence, the organic film needs to withstand the temperature of 300 to 500°C. Since the organic film formed using the inventive material for forming an organic film has high heat resistance and can withstand high temperatures of 300°C to 500°C, this enables the combination of the inorganic hard mask middle layer film formed by a CVD method or an ALD method with the organic film formed by a spin-coating method.

### [4-Layer Resist Method using Inorganic Hard Mask Middle Layer Film and Organic Antireflective Coating]

Furthermore, the present invention provides a patterning process for forming a pattern in a substrate to be processed, the process including:
forming an organic film on the substrate to be processed by using the above-described material for forming an organic film;
forming an inorganic hard mask middle layer film selected from a silicon oxide film, a silicon nitride film, a silicon oxynitride film, a titanium oxide film, and a titanium nitride film on the organic film;
forming an organic antireflective coating on the inorganic hard mask middle layer film;
forming a resist upper layer film on the organic antireflective coating by using a photoresist composition, so that a 4-layered film structure is constructed;
forming a circuit pattern in the resist upper layer film;
transferring the pattern to the organic antireflective coating and the inorganic hard mask middle layer film by etching while using the resist upper layer film having the formed pattern as a mask;
transferring the pattern to the organic film by etching while using the inorganic hard mask middle layer film having the transferred pattern as a mask; and
further transferring the pattern to the substrate to be processed by etching while using the organic film having the transferred pattern as a mask.

Note that this method can be performed in the same manner as the above-described three-layer resist method using the inorganic hard mask middle layer film, except that the organic antireflective coating (BARC) is formed between the inorganic hard mask middle layer film and the resist upper layer film.

Particularly, when the SiON film is used as the inorganic hard mask middle layer film, two antireflective coatings including the SiON film and the BARC make it possible to suppress the reflection even in liquid immersion exposure at a high NA exceeding 1.0. Another merit of the BARC formation is having an effect of reducing footing of the resist upper layer film pattern immediately above the SiON film.

Herein, FIG. 2 (A) to (F) show an example of the inventive patterning process according to the three-layer resist method. In the three-layer resist method, as shown in FIG. 2 (A), using the inventive material for forming an organic film, an organic film 3 is formed on a layer 2 to be processed formed on a substrate 1. Then, a silicon-containing resist middle layer film 4 is formed, and a resist upper layer film 5 is formed thereon. Subsequently, as shown in FIG. 2 (B), a portion 6 to be exposed of the resist upper layer film 5 is exposed to light, followed by PEB (post-exposure bake). Thereafter, as shown in FIG. 2 (C), a resist upper layer film pattern 5a is formed by development. After that, as shown in FIG. 2 (D), using the resist upper layer film pattern 5a as a mask, the silicon-containing resist middle layer film 4 is processed by dry-etching with a fluorocarbon-based gas. Thereby, a silicon-containing resist middle layer film pattern 4a is formed. Then, as shown in FIG. 2 (E), after the resist upper layer film pattern 5a is removed, the organic film 3 is etched with oxygen plasma while using the silicon-containing resist middle layer film pattern 4a as a mask. Thereby, an organic film pattern 3a is formed. Further, as shown in FIG. 2 (F), after the silicon-containing resist middle layer film pattern 4a is removed, the layer 2 to be processed is processed by etching while using the organic film pattern 3a as a mask. Thus, a pattern 2a is formed.

In the case where an inorganic hard mask middle layer film is formed, the silicon-containing resist middle layer film 4 may be replaced with the inorganic hard mask middle layer film. In the case where a BARC is formed, the BARC may be formed between the silicon-containing resist middle layer film 4 and the resist upper layer film 5. The etching of the BARC starts before the etching of the silicon-containing resist middle layer film 4, but these etchings may be performed continuously. Alternatively, after the BARC is etched alone, the etching apparatus is changed, for example, and then the silicon-containing resist middle layer film 4 may be etched.

As described above, the inventive patterning processes make it possible to precisely form a fine pattern in a substrate to be processed by the multilayer resist methods.

### EXAMPLE

Hereinafter, the present invention will be more specifically described with reference to Synthesis Examples, Examples, and Comparative Examples. However, the present invention is not limited thereto but defined in the claims. Note that, with respect to molecular weight and dispersity, weight-average molecular weight (Mw) and number-average molecular weight (Mn) were measured by gel permeation chromatography (GPC) using tetrahydrofuran as an eluent in terms of polystyrene, and dispersity (Mw/Mn) was calculated therefrom.

### Synthesis Examples: Synthesis of Compounds for Forming Organic Film

Compounds (A1) to (A21) for forming an organic film were synthesized using Phenols or Aniline: (B1) to (B9) and Fluorobenzenes: (C1) to (C7) shown below. Moreover, Compounds (R1) to (R5) for Comparative Examples were synthesized using Synthesis raw materials (D1) to (D8) for Comparative Examples.

### Phenols or Aniline:

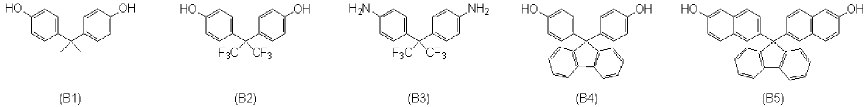

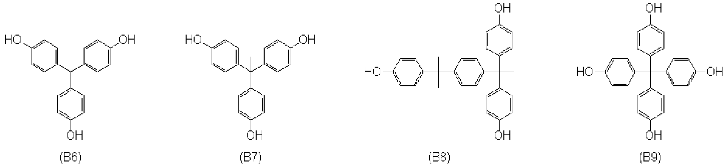

### Fluorobenzenes:

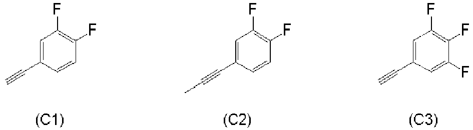

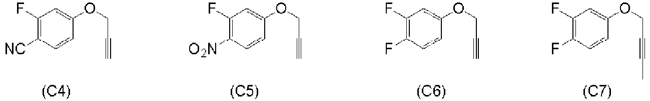

Synthesis raw materials for Comparative Examples:

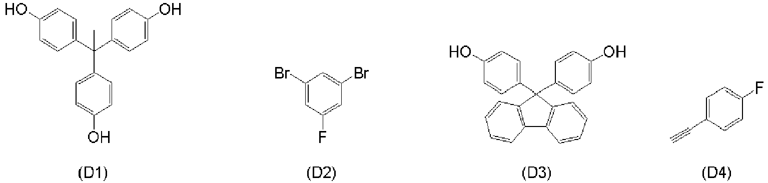

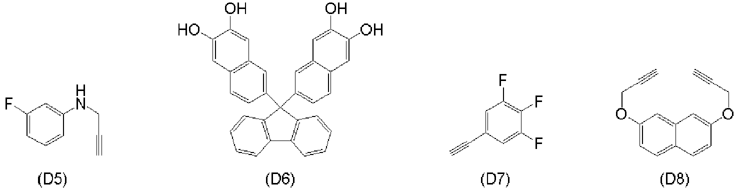

### [Synthesis Example 1] Synthesis of Compound (A1) for Forming Organic Film

To 3.4 g of Phenol (B1), 4.1 g of Fluorobenzene (C1), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A1) was obtained. When the weight-average molecular weight (Mw) and dispersity (Mw/Mn) were determined by GPC, the following results were obtained.

(A1): Mw=680, Mw/Mn=1.30

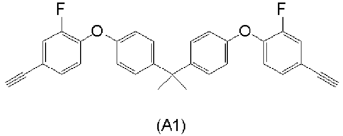

### [Synthesis Example 2] Synthesis of Compound (A2) for Forming Organic Film

To 5.0 g of Phenol (B2), 4.1 g of Fluorobenzene (C1), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A2) was obtained. When the weight-average molecular weight (Mw) and dispersity (Mw/Mn) were determined by GPC, the following results were obtained.

(A2): Mw=690, Mw/Mn=1.30

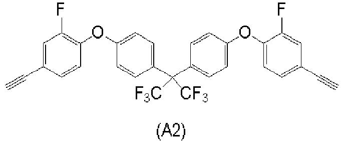

### [Synthesis Example 3] Synthesis of Compound (A3) for Forming Organic Film

To 5.0 g of Aniline (B3), 4.1 g of Fluorobenzene (C1), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A3) was obtained. When the weight-average molecular weight (Mw) and dispersity (Mw/Mn) were determined by GPC, the following results were obtained.

(A3): Mw=680, Mw/Mn=1.28

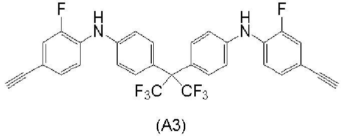

### [Synthesis Example 4] Synthesis of Compound (A4) for Forming Organic Film

To 5.2 g of Phenol (B4), 4.1 g of Fluorobenzene (C1), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A4) was obtained. When the weight-average molecular weight (Mw) and dispersity (Mw/Mn) were determined by GPC, the following results were obtained.

(A4): Mw=780, Mw/Mn=1.32

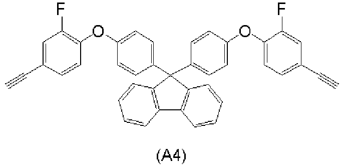

### [Synthesis Example 5] Synthesis of Compound (A5) for Forming Organic Film

To 6.8 g of Phenol (B5), 4.1 g of Fluorobenzene (C1), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A5) was obtained. When the weight-average molecular weight (Mw) and dispersity (Mw/Mn) were determined by GPC, the following results were obtained.

(A5): Mw=910, Mw/Mn=1.33

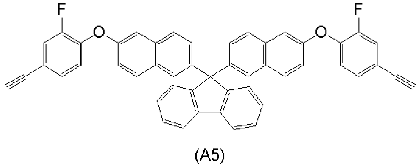

### [Synthesis Example 6] Synthesis of Compound (A6) for Forming Organic Film

To 2.9 g of Phenol (B6), 4.1 g of Fluorobenzene (C1), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A6) was obtained. When the weight-average molecular weight (Mw) and dispersity (Mw/Mn) were determined by GPC, the following results were obtained.

(A6): Mw=1420, Mw/Mn=1.35

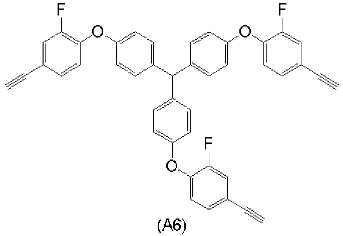

### [Synthesis Example 7] Synthesis of Compound (A7) for Forming Organic Film

To 3.1 g of Phenol (B7), 4.1 g of Fluorobenzene (C1), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A7) was obtained. When the weight-average molecular weight (Mw) and dispersity (Mw/Mn) were determined by GPC, the following results were obtained.

(A7): Mw=1260, Mw/Mn=1.34

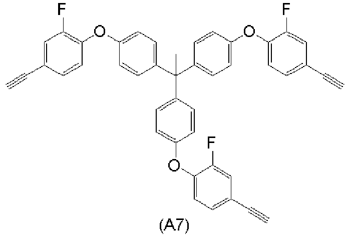

### [Synthesis Example 8] Synthesis of Compound (A8) for Forming Organic Film

To 3.1 g of Phenol (B7), 4.6 g of Fluorobenzene (C2), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A8) was obtained. When the weight-average molecular weight (Mw) and dispersity (Mw/Mn) were determined by GPC, the following results were obtained.

(A8): Mw=1310, Mw/Mn=1.35

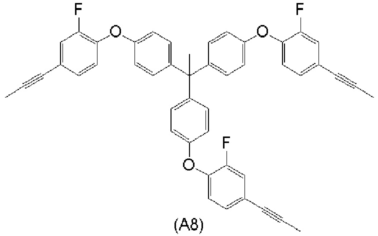

### [Synthesis Example 9] Synthesis of Compound (A9) for Forming Organic Film

To 3.1 g of Phenol (B7), 4.7 g of Fluorobenzene (C3), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A9) was obtained. When the weight-average molecular weight (Mw) and dispersity (Mw/Mn) were determined by GPC, the following results were obtained.

(A9): Mw=1370, Mw/Mn=1.35

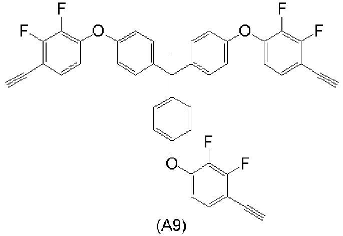

### [Synthesis Example 10] Synthesis of Compound (A10) for Forming Organic Film

To 4.2 g of Phenol (B8), 4.1 g of Fluorobenzene (C1), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A10) was obtained. When the weight-average molecular weight (Mw) and dispersity (Mw/Mn) were determined by GPC, the following results were obtained.

(A10): Mw=1350, Mw/Mn=1.27

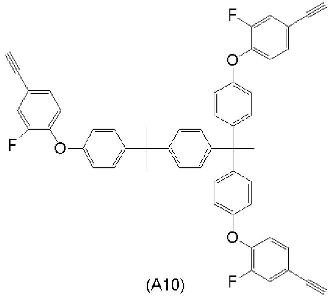

### [Synthesis Example 11] Synthesis of Compound (A11) for Forming Organic Film

To 3.8 g of Phenol (B9), 5.5 g of Fluorobenzene (C1), and 5.5 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A11) was obtained. When the weight-average molecular weight (Mw) and dispersity (Mw/Mn) were determined by GPC, the following results were obtained.

(A11): Mw=1550, Mw/Mn=1.30

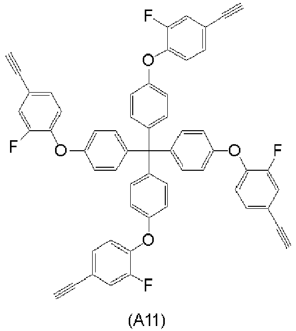

### [Synthesis Example 12] Synthesis of Compound (A12) for Forming Organic Film

To 3.4 g of Phenol (B1), 5.2 g of Fluorobenzene (C4), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A12) was obtained. When the weight-average molecular weight (Mw) and dispersity (Mw/Mn) were determined by GPC, the following results were obtained.

(A12): Mw=1100, Mw/Mn=1.35

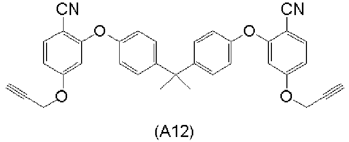

### [Synthesis Example 13] Synthesis of Compound (A13) for Forming Organic Film

To 5.2 g of Phenol (B4), 5.2 g of Fluorobenzene (C4), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A13) was obtained. When the weight-average molecular weight (Mw) and dispersity (Mw/Mn) were determined by GPC, the following results were obtained.

(A13): Mw=840, Mw/Mn=1.11

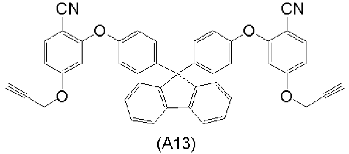

### [Synthesis Example 14] Synthesis of Compound (A14) for Forming Organic Film

To 6.8 g of Phenol (B5), 5.2 g of Fluorobenzene (C4), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A14) was obtained. When the weight-average molecular weight (Mw) and dispersity (Mw/Mn) were determined by GPC, the following results were obtained.

(A14): Mw=940, Mw/Mn=1.13

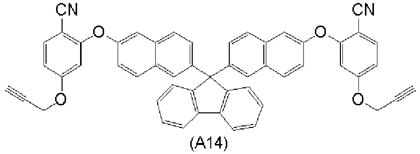

### [Synthesis Example 15] Synthesis of Compound (A15) for Forming Organic Film

To 3.1 g of Phenol (B7), 5.2 g of Fluorobenzene (C4), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A15) was obtained. When the weight-average molecular weight (Mw) and dispersity (Mw/Mn) were determined by GPC, the following results were obtained.

(A15): Mw=1040, Mw/Mn=1.03

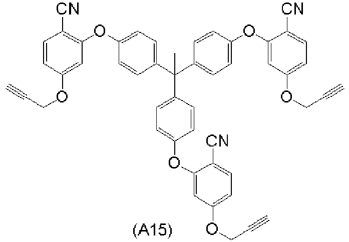

### [Synthesis Example 16] Synthesis of Compound (A16) for Forming Organic Film

To 3.1 g of Phenol (B7), 5.8 g of Fluorobenzene (C5), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A16) was obtained. When the weight-average molecular weight (Mw) and dispersity (Mw/Mn) were determined by GPC, the following results were obtained.

(A16): Mw=870, Mw/Mn=1.00

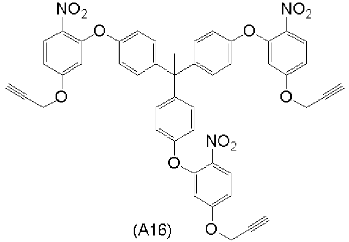

### [Synthesis Example 17] Synthesis of Compound (A17) for Forming Organic Film

To 3.1 g of Phenol (B7), 5.0 g of Fluorobenzene (C6), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A17) was obtained. When the weight-average molecular weight (Mw) and dispersity (Mw/Mn) were determined by GPC, the following results were obtained.

(A17): Mw=1350, Mw/Mn=1.34

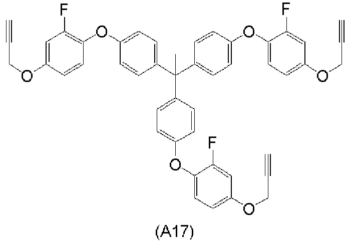

### [Synthesis Example 18] Synthesis of Compound (A18) for Forming Organic Film

To 3.1 g of Phenol (B7), 5.5 g of Fluorobenzene (C7), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A18) was obtained. When the weight-average molecular weight (Mw) and dispersity (Mw/Mn) were determined by GPC, the following results were obtained.

(A18): Mw=1390, Mw/Mn=1.32

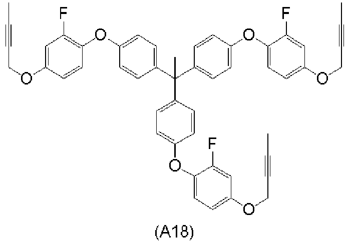

### [Synthesis Example 19] Synthesis of Compound (A19) for Forming Organic Film

To 2.9 g of Phenol (B6), 5.0 g of Fluorobenzene (C6), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A19) was obtained. When the weight-average molecular weight (Mw) and dispersity (Mw/Mn) were determined by GPC, the following results were obtained.

(A19): Mw=1410, Mw/Mn=1.35

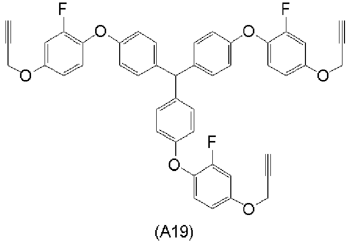

### [Synthesis Example 20] Synthesis of Compound (A20) for Forming Organic Film

To 4.2 g of Phenol (B8), 5.0 g of Fluorobenzene (C6), and 4.1 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A20) was obtained. When the weight-average molecular weight (Mw) and dispersity (Mw/Mn) were determined by GPC, the following results were obtained.

(A20): Mw=1430, Mw/Mn=1.33

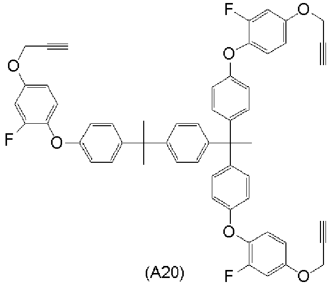

### [Synthesis Example 21] Synthesis of Compound (A21) for Forming Organic Film

To 3.8 g of Phenol (B9), 6.7 g of Fluorobenzene (C6), and 5.5 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (A21) was obtained. When the weight-average molecular weight (Mw) and dispersity (Mw/Mn) were determined by GPC, the following results were obtained.

(A21): Mw=1580, Mw/Mn=1.34

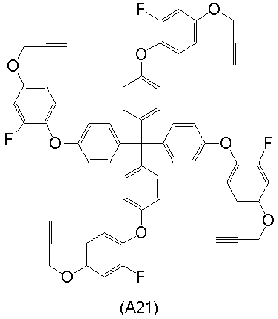

### [Synthesis Example 22] Synthesis of Compound (R1) for Comparative Examples

A 500-mL four-necked flask was charged with 6.1 g of Synthesis raw material (D1) for Comparative Examples, 15.2 g of Synthesis raw material (D2) for Comparative Examples, 13.8 g of potassium carbonate, 100 g of toluene, and 200 g of DMSO. These were stirred under nitrogen stream while the temperature was kept at 120°C for 5 hr. Toluene, acetic acid, and water were added to the resultant, the solution was separated, and the oil layer was distilled off under reduced pressure. Thereby, a hexabromo derivative was obtained.

A 500-mL four-necked flask was charged with the hexabromo derivative obtained above, 200 g of triethylamine, and 0.8 g of CuI(I). These were stirred under Ar stream at room temperature for 30 minutes. After 2.7 g of Pd(0) (TPP)₄ and 11.8 g of trimethylsilylacetylene were added thereto, the temperature was raised to 80°C, and the mixture was stirred while the temperature was kept for 5 hr. The reaction mass was filtered, and the filtrate was concentrated. Then, the resultant was subjected to column treatment with toluene and concentrated. Thereby, a hexa(trimethylsilylethynyl)derivative was obtained.

The hexa(trimethylsilylethynyl)derivative obtained above was directly charged into a 300-mL four-necked flask, and 50 g of toluene, 50 g of methanol, and 16.5 g of potassium carbonate were charged therein and stirred at room temperature for 18 hours. The reaction mass was directly neutralized with acetic acid, and toluene was added thereto, followed by water washing. Subsequently, toluene was distilled off under reduced pressure. Thus, (R1) was obtained. When the weight-average molecular weight (Mw) and dispersity (Mw/Mn) were determined by GPC, the following results were obtained.

(R1): Mw=970, Mw/Mn=1.03

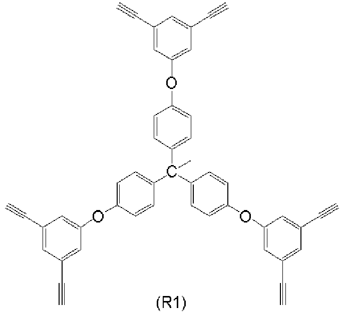

### [Synthesis Example 23] Synthesis of Compound (R2) for Comparative Examples

To 20.0 g of Synthesis raw material (D3) for Comparative Examples, 16.4 g of Synthesis raw material (D4) for Comparative Examples, and 23.3 g of potassium carbonate, 200 g of N-methylpyrrolidone was added, and the reaction was allowed to proceed with an inner temperature of 140°C for 24 hours under nitrogen atmosphere. After cooling at room temperature, 300 ml of methyl isobutyl ketone and 300 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 100 g of THF was added and a homogeneous solution was formed. Thereafter, a crystal was precipitated with 350 g of methanol. The precipitated crystal was separated by filtration, washed twice with 200 g of methanol, and collected. The collected crystal was vacuum dried at 70°C. Thus, (R2) was obtained. When the weight-average molecular weight (Mw) and dispersity (Mw/Mn) were determined by GPC, the following results were obtained.

(R2): Mw=580, Mw/Mn=1.03

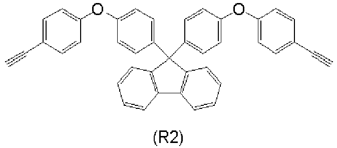

### [Synthesis Example 24] Synthesis of Compounds (R3) for Comparative Examples

To 10.0 g of Synthesis raw material (D3) for Comparative Examples, 8.5 g of Synthesis raw material (D5) for Comparative Examples, and 7.9 g of potassium carbonate, 40 g of N-methylpyrrolidone was added, and the reaction was allowed to proceed with an inner temperature of 140°C for 24 hours under nitrogen atmosphere. After cooling at room temperature, 100 ml of methyl isobutyl ketone and 100 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 10 g of THF was added and a homogeneous solution was formed. Thereafter, a crystal was precipitated with 50 g of methanol. The precipitated crystal was separated by filtration, washed twice with 20 g of methanol, and collected. The collected crystal was vacuum dried at 70°C. Thus, (R3) was obtained. When the weight-average molecular weight (Mw) and dispersity (Mw/Mn) were determined by GPC, the following results were obtained.

(R3): Mw=1550, Mw/Mn=1.85

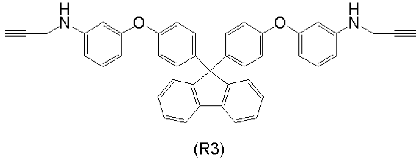

### [Synthesis Example 25] Synthesis of Compounds (R4) for Comparative Examples

To 20.0 g of Synthesis raw material (D6) for Comparative Examples, 16.2 g of Synthesis raw material (D7) for Comparative Examples, and 25.4 g of potassium carbonate, 200 g of N-methylpyrrolidone was added, and the reaction was allowed to proceed with an inner temperature of 120°C for 8 hours under nitrogen atmosphere. After cooling at room temperature, 300 ml of methyl isobutyl ketone and 300 ml of pure water were added to the reaction solution and homogenized. Then, the separated aqueous layer was removed. Further, the organic layer was washed twice with 100 ml of a 3% nitric acid aqueous solution and five times with 100 ml of pure water. Subsequently, the organic layer was dried under reduced pressure. To the residue, 100 g of THF was added and a homogeneous solution was formed. Thereafter, a crystal was precipitated with 400 g of methanol. The precipitated crystal was separated by filtration, washed twice with 300 g of methanol, and collected. The collected crystal was vacuum dried at 70°C. Thus, (R4) was obtained as a mixture shown below. The isomer ratio determined by LC is also shown. Moreover, when the weight-average molecular weight (Mw) and dispersity (Mw/Mn) were determined by GPC, the following results were obtained.

(R4): Mw=760, Mw/Mn=1.04

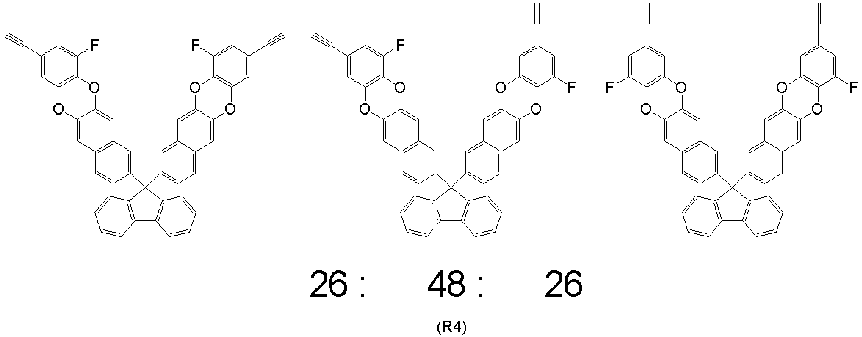

### [Synthesis Example 26] Synthesis of Compounds (R5) for Comparative Examples

Under nitrogen atmosphere, a homogeneous solution with a liquid temperature of 70°C was prepared from 80 g of Synthesis raw material (D8) for Comparative Examples, 22 g of a 37% formalin solution, and 250 g of 1,2-dichloroethane. Then, 5 g of methanesulfonic acid was slowly added thereto, and the reaction was allowed to proceed with the liquid temperature of 80°C for 12 hours. After cooling to room temperature, 500 ml of MIBK was added, and the organic layer was washed five times with 200 g of pure water. Subsequently, the organic layer was dried under reduced pressure. To the residue, 300 g of THF was added and a homogeneous solution was formed. Thereafter, a polymer was reprecipitated with 2000 g of hexane. The precipitated polymer was separated by filtration and dried under reduced pressure. Thus, Compound (R5) was obtained. When the weight-average molecular weight (Mw) and dispersity (Mw/Mn) were determined by GPC, the following results were obtained.

(R5): Mw=3000, Mw/Mn=1.58

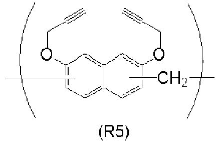

### Preparation of Materials (UDL-1 to -23, Comparative UDL-1 to -5) for Forming Organic Film

According to proportions shown in Table 1, Compounds (A1) to (A21) for forming an organic film and Compounds (R1) to (R5) for Comparative Examples described above were dissolved in organic solvents of propylene glycol monomethyl ether acetate (PGMEA) containing 0.1 mass% FC-4430 (manufactured by Sumitomo 3M Ltd.), and optionally a high-boiling-point solvent of (S1) 1,6-diacetoxyhexane: boiling point of 260°C or (S2) tripropylene glycol monomethyl ether: boiling point of 242°C. The resulting solutions were filtered through a 0.1-µm filter made of a fluorinated resin. Thus, materials (UDL-1 to -23, Comparative UDL-1 to -5) for forming an organic film were prepared.

**[Table 1]**

| Material for forming organic film | Compound (parts by mass) | High-boiling-point solvent (parts by mass) | PGMEA (parts by mass) |
|---|---|---|---|
| UDL-1 | A1 (10) | - | 90 |
| UDL-2 | A2 (10) | - | 90 |
| UDL-3 | A3 (10) | - | 90 |
| UDL-4 | A4 (10) | - | 90 |
| UDL-5 | A5 (10) | - | 90 |
| UDL-6 | A6 (10) | - | 90 |
| UDL-7 | A7 (10) | - | 90 |
| UDL-8 | A8 (10) | - | 90 |
| UDL-9 | A9 (10) | - | 90 |
| UDL-10 | A10 (10) | - | 90 |
| UDL-11 | A11 (10) | - | 90 |
| UDL-12 | A12 (10) | - | 90 |
| UDL-13 | A13 (10) | - | 90 |
| UDL-14 | A14 (10) | - | 90 |
| UDL-15 | A15 (10) | - | 90 |
| UDL-16 | A16 (10) | - | 90 |
| UDL-17 | A17 (10) | - | 90 |
| UDL-18 | A18 (10) | - | 90 |
| UDL-19 | A19 (10) | - | 90 |
| UDL-20 | A20 (10) | - | 90 |
| UDL-21 | A21 (10) | - | 90 |
| UDL-22 | A7 (10) | S1 (10) | 80 |
| UDL-23 | A7 (10) | S2 (10) | 80 |
| Comparative UDL-1 | R1 (10) | - | 90 |
| Comparative UDL-2 | R2 (10) | - | 90 |
| Comparative UDL-3 | R3 (10) | - | 90 |
| Comparative UDL-4 | R4 (10) | - | 90 |
| Comparative UDL-5 | R5 (10) | - | 90 |

### Example 1: Solvent Resistance Measurement (Examples 1-1 to 1-23, Comparative Examples 1-1 to 1-5)

The materials (UDL-1 to -23, Comparative UDL-1 to - 5) for forming an organic film prepared above were each applied onto a silicon substrate, and baked in air at 400°C for 60 seconds. Then, the film thickness was measured. A PGMEA solvent was dispensed on each film and left standing for 30 seconds. The resultant was spin-dried and baked at 100°C for 60 seconds to evaporate the PGMEA solvent, and the film thickness was measured again. A difference in film thicknesses before and after the PGMEA treatment was determined to evaluate the solvent resistance. Table 2 shows the results.

**[Table 2]**

| | Material for forming organic film | Film thickness after film formation: a (Å) | Film thickness after PGMEA treatment: b (Å) | b/a × 100 (%) |
|---|---|---|---|---|
| Example 1-1 | UDL-1 | 2002 | 2001 | 100.0 |
| Example 1-2 | UDL-2 | 1998 | 1995 | 99.8 |
| Example 1-3 | UDL-3 | 2003 | 2000 | 99.9 |
| Example 1-4 | UDL-4 | 1996 | 1994 | 99.9 |
| Example 1-5 | UDL-5 | 2001 | 1998 | 99.9 |
| Example 1-6 | UDL-6 | 1997 | 1995 | 99.9 |
| Example 1-7 | UDL-7 | 2003 | 2002 | 100.0 |
| Example 1-8 | UDL-8 | 2003 | 2001 | 99.9 |
| Example 1-9 | UDL-9 | 1996 | 1994 | 99.9 |
| Example 1-10 | UDL-10 | 2003 | 2000 | 99.9 |
| Example 1-11 | UDL-11 | 2000 | 1998 | 99.9 |
| Example 1-12 | UDL-12 | 2004 | 2002 | 99.9 |
| Example 1-13 | UDL-13 | 2001 | 2000 | 100.0 |
| Example 1-14 | UDL-14 | 2009 | 2005 | 99.8 |
| Example 1-15 | UDL-15 | 1999 | 1997 | 99.9 |
| Example 1-16 | UDL-16 | 2004 | 2001 | 99.9 |
| Example 1-17 | UDL-17 | 1998 | 1996 | 99.9 |
| Example 1-18 | UDL-18 | 2000 | 1997 | 99.9 |
| Example 1-19 | UDL-19 | 1996 | 1995 | 99.9 |
| Example 1-20 | UDL-20 | 2003 | 2001 | 99.9 |
| Example 1-21 | UDL-21 | 1995 | 1993 | 99.9 |
| Example 1-22 | UDL-22 | 2001 | 2000 | 100.0 |
| Example 1-23 | UDL-23 | 1998 | 1996 | 99.9 |
| Comparative Example 1-1 | Comparative UDL-1 | 2007 | 2006 | 100.0 |
| Comparative Example 1-2 | Comparative UDL-2 | 1998 | 1994 | 99.8 |
| Comparative Example 1-3 | Comparative UDL-3 | 2001 | 1998 | 99.9 |
| Comparative Example 1-4 | Comparative UDL-4 | 2003 | 2002 | 100.0 |
| Comparative Example 1-5 | Comparative UDL-5 | 1997 | 1990 | 99.6 |

It can be seen as shown in Table 2 that the inventive materials (Examples 1-1 to 1-23) for forming an organic film caused little film reductions in the solvent treatment, and resulted in films with favorable solvent resistance. It was found that sufficient solvent resistance was exhibited even when electron-attracting groups were bonded on benzene rings with triple bond-containing terminal groups.

### Example 2: Heat Resistance Evaluation (Examples 2-1 to 2-23, Comparative Examples 2-1 to 2-5)

The materials (UDL-1 to -23, Comparative UDL-1 to - 5) for forming an organic film were each applied onto a silicon substrate, and baked in air at 180°C to form a coating film of 200 nm. The film thickness was measured. This substrate was further baked at 400°C for 10 minutes under such a nitrogen stream that the oxygen concentration was controlled to 0.2% or less. Then, the film thickness was measured. These results are shown in Table 3.

**[Table 3]**

| | Material for forming organic film | Film thickness at 180°C: A (Å) | Film thickness at 400°C: B (Å) | Film remaining percentage: % (B/A) |
|---|---|---|---|---|
| Example 2-1 | UDL-1 | 2005 | 1971 | 98.3 |
| Example 2-2 | UDL-2 | 2001 | 1968 | 98.4 |
| Example 2-3 | UDL-3 | 2006 | 1967 | 98.1 |
| Example 2-4 | UDL-4 | 1999 | 1980 | 99.0 |
| Example 2-5 | UDL-5 | 2000 | 1986 | 99.3 |
| Example 2-6 | UDL-6 | 1998 | 1967 | 98.4 |
| Example 2-7 | UDL-7 | 2007 | 1978 | 98.6 |
| Example 2-8 | UDL-8 | 2004 | 1964 | 98.0 |
| Example 2-9 | UDL-9 | 1998 | 1959 | 98.0 |
| Example 2-10 | UDL-10 | 2006 | 1972 | 98.3 |
| Example 2-11 | UDL-11 | 2004 | 1978 | 98.7 |
| Example 2-12 | UDL-12 | 2008 | 1951 | 97.2 |
| Example 2-13 | UDL-13 | 2003 | 1956 | 97.7 |
| Example 2-14 | UDL-14 | 2006 | 1962 | 97.8 |
| Example 2-15 | UDL-15 | 1997 | 1948 | 97.5 |
| Example 2-16 | UDL-16 | 2006 | 1945 | 97.0 |
| Example 2-17 | UDL-17 | 2001 | 1949 | 97.4 |
| Example 2-18 | UDL-18 | 1995 | 1937 | 97.1 |
| Example 2-19 | UDL-19 | 1998 | 1957 | 97.9 |
| Example 2-20 | UDL-20 | 2005 | 1952 | 97.4 |
| Example 2-21 | UDL-21 | 1998 | 1948 | 97.5 |
| Example 2-22 | UDL-22 | 2002 | 1969 | 98.4 |
| Example 2-23 | UDL-23 | 2003 | 1972 | 98.5 |
| Comparative Example 2-1 | Comparative UDL-1 | 2005 | 1971 | 98.3 |
| Comparative Example 2-2 | Comparative UDL-2 | 2001 | 1982 | 99.1 |
| Comparative Example 2-3 | Comparative UDL-3 | 2007 | 1761 | 87.7 |
| Comparative Example 2-4 | Comparative UDL-4 | 2009 | 2000 | 99.6 |
| Comparative Example 2-5 | Comparative UDL-5 | 2002 | 1732 | 86.5 |

As shown in Table 3, with the inventive materials (Examples 2-1 to 2-23) for forming an organic film, the film thicknesses were decreased by 3% or less even after the baking at 400°C for 10 minutes. The inventive materials for forming an organic film are capable of forming organic films having high heat resistance even under the high-temperature conditions of 400°C. It was found that excellent heat resistance is achieved even when the materials have all of: a hydrocarbon group having 1 to 15 carbon atoms optionally substituted with a fluorine atom, a diaryl ether structure or diaryl amine structure, and a structure with an electron-attracting group bonded on a benzene ring with a triple bond-containing terminal group. In contrast, in Comparative Examples 2-3 and 2-5, the film thicknesses were greatly decreased by more than 10%. This indicated that the novolak structure and the compound having a structure with one propargyl group bonded to a nitrogen atom do not have high heat resistance under the high-temperature conditions of 400°C. These suggest that an ethynyl structure or propargyl ether structure as shown in the formula (1B) at R₁ of the general formula (1A) in the present invention contributes to high heat resistance.

### Example 3: Filling Property Evaluation (Examples 3-1 to 3-23, Comparative Examples 3-1 to 3-5)

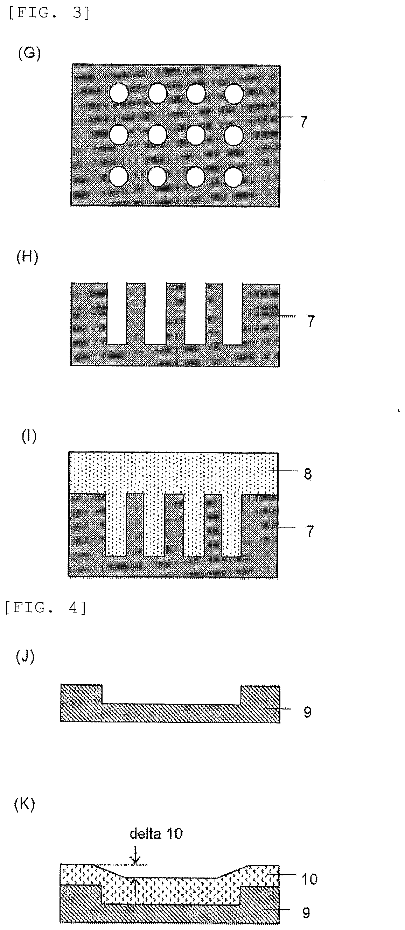

As shown in FIG. 3, the materials (UDL-1 to -23, Comparative UDL-1 to -5) for forming an organic film were each applied onto a SiO₂ wafer substrate having a dense hole pattern (hole diameter: 0.16 µm, hole depth: 0.50 µm, distance between the centers of two adjacent holes: 0.32 µm), and baked in air at 400°C for 60 seconds to form an organic film 8. The substrates thus used were base substrates 7 (SiO₂ wafer substrates) each having a dense hole pattern as shown in FIG. 3 (G) (top view) and (H) (sectional view). The sectional shapes of the resulting wafer substrates were observed with a scanning electron microscope (SEM) to check whether the insides of the holes were filled with the organic film 8 without voids (space). Table 4 shows the result. If an organic film material inferior in filling property is used in this evaluation, voids occur inside the holes. If an organic film material having favorable filling property is used in this evaluation, the insides of the holes are filled with an organic film 8 without voids as shown in FIG. 3 (I).

**[Table 4]**

| | Material for forming organic film | Presence/absence of voids |
|---|---|---|
| Example 3-1 | UDL-1 | absent |
| Example 3-2 | UDL-2 | absent |
| Example 3-3 | UDL-3 | absent |
| Example 3-4 | UDL-4 | absent |
| Example 3-5 | UDL-5 | absent |
| Example 3-6 | UDL-6 | absent |
| Example 3-7 | UDL-7 | absent |
| Example 3-8 | UDL-8 | absent |
| Example 3-9 | UDL-9 | absent |
| Example 3-10 | UDL-10 | absent |
| Example 3-11 | UDL-11 | absent |
| Example 3-12 | UDL-12 | absent |
| Example 3-13 | UDL-13 | absent |
| Example 3-14 | UDL-14 | absent |
| Example 3-15 | UDL-15 | absent |
| Example 3-16 | UDL-16 | absent |
| Example 3-17 | UDL-17 | absent |
| Example 3-18 | UDL-18 | absent |
| Example 3-19 | UDL-19 | absent |
| Example 3-20 | UDL-20 | absent |
| Example 3-21 | UDL-21 | absent |
| Example 3-22 | UDL-22 | absent |
| Example 3-23 | UDL-23 | absent |
| Comparative Example 3-1 | Comparative UDL-1 | absent |
| Comparative Example 3-2 | Comparative UDL-2 | absent |
| Comparative Example 3-3 | Comparative UDL-3 | present |
| Comparative Example 3-4 | Comparative UDL-4 | absent |
| Comparative Example 3-5 | Comparative UDL-5 | present |

As shown in Table 4, it was verified that the inventive materials (Examples 3-1 to 3-23) for forming an organic film were capable of filling the hole pattern without voids and had favorable filling property. Meanwhile, in Comparative Examples 3-3 and 3-5, voids were caused by insufficient heat resistance as demonstrated in the results of Example 2. This result confirmed that the inventive materials for forming an organic film have favorable filling property.

### Example 4: Planarizing Property Evaluation (Examples 4-1 to 4-23, Comparative Examples 4-1 to 4-5)

The materials (UDL-1 to -23, Comparative UDL-1 to - 5) for forming an organic film were each applied onto a base substrate 9 (SiO₂ wafer substrate) having a giant isolated trench pattern (FIG. 4 (J), trench width: 25 µm, trench depth: 0.10 µm), and baked in air at 400°C for 60 seconds to form an organic film 10. Then, a step delta 10 (FIG. 4 (K)) between the trench portion and the non-trench portion of each organic film was observed with D-600 (probe type profiler) manufactured by KLA-Tencor Corporation. Table 5 shows the results. In this evaluation, the smaller the step, the more favorable the planarizing property. Note that, in this evaluation, a trench pattern with depths of 0.10 µm was planarized using an organic film material generally having a film thickness of approximately 0.2 µm. This is a strict evaluation condition to evaluate the planarizing property.

**[Table 5]**

| | Material for forming organic film | Step |
|---|---|---|
| | | (nm) |
| Example 4-1 | UDL-1 | 25 |
| Example 4-2 | UDL-2 | 25 |
| Example 4-3 | UDL-3 | 25 |
| Example 4-4 | UDL-4 | 30 |
| Example 4-5 | UDL-5 | 30 |
| Example 4-6 | UDL-6 | 20 |
| Example 4-7 | UDL-7 | 20 |
| Example 4-8 | UDL-8 | 20 |
| Example 4-9 | UDL-9 | 25 |
| Example 4-10 | UDL-10 | 30 |
| Example 4-11 | UDL-11 | 30 |
| Example 4-12 | UDL-12 | 20 |
| Example 4-13 | UDL-13 | 25 |
| Example 4-14 | UDL-14 | 30 |
| Example 4-15 | UDL-15 | 25 |
| Example 4-16 | UDL-16 | 20 |
| Example 4-17 | UDL-17 | 20 |
| Example 4-18 | UDL-18 | 25 |
| Example 4-19 | UDL-19 | 20 |
| Example 4-20 | UDL-20 | 30 |
| Example 4-21 | UDL-21 | 30 |
| Example 4-22 | UDL-22 | 15 |
| Example 4-23 | UDL-23 | 15 |
| Comparative Example 4-1 | Comparative UDL-1 | 95 |
| Comparative Example 4-2 | Comparative UDL-2 | 80 |
| Comparative Example 4-3 | Comparative UDL-3 | 105 |
| Comparative Example 4-4 | Comparative UDL-4 | 90 |
| Comparative Example 4-5 | Comparative UDL-5 | 120 |

As shown in Table 5, it was verified that the inventive materials (Examples 4-1 to 4-23) for forming an organic film resulted in the organic films which had smaller steps between the trench and non-trench portions than those in Comparative Examples 4-1 to 4-5, and that the planarizing property was excellent. In Comparative Examples 4-1, 4-2, and 4-3, since no electron-attracting group is bonded on a benzene ring with a triple bond-containing terminal group, the intermolecular interaction is not relieved, and the crosslinking temperature is so low that planarizing property owing to thermal flow is not ensured; consequently, the planarizing property was poor. In Comparative Example 4-4, the benzene rings with triple bond-containing terminal groups have fluorine atoms, but the material has a dioxane ring structure but no diaryl ether structure. Hence, the flowability was insufficient at the wide trench portion, and the planarizing property was consequently poor. In Comparative Examples 4-3 and 4-5, the films shrank considerably by the 400°C baking, and the planarizing property was consequently poor. These were because of the insufficient heat resistance as demonstrated by the results of Comparative Examples 2 in Heat Resistance Evaluation. Meanwhile, the comparison of Examples 4-22, 4-23, in which the high-boiling-point solvent was added, with Example 4-7, in which no high-boiling-point solvent was added, revealed that adding the high-boiling-point solvent further improves planarizing property. These results reveal that the inventive materials for forming an organic film suppress film shrinking during high-temperature baking because of the excellent heat resistance, and exhibit excellent planarizing property.

### Example 5: Patterning Test (Examples 5-1 to 5-23, Comparative Examples 5-1 to 5-3)

The materials (UDL-1 to -23, Comparative UDL-1, -2, -4) for forming an organic film were each applied onto a base substrate 9 (SiO₂ wafer substrate) having a giant isolated trench pattern (FIG. 4 (J), trench width: 25 µm, trench depth: 0.10 µm), and baked in air at 400°C for 60 seconds to form an organic film (resist underlayer film). A CVD-SiON hard mask middle layer film was formed at 400°C thereon. Further, an organic antireflective coating material (ARC-29A: manufactured by Nissan Chemical Industries, Ltd.) was applied and baked at 210°C for 60 seconds to form an organic antireflective coating having a film thickness of 80 nm. A resist upper layer film material was applied thereon as a monolayer resist for ArF and baked at 105°C for 60 seconds to form a photoresist film having a film thickness of 100 nm. The photoresist film was coated with a liquid immersion top coat material (TC-1) and baked at 90°C for 60 seconds to form a top coat having a film thickness of 50 nm. Note that regarding Comparative UDL-3 and Comparative UDL-5, it was impossible to form a CVD-SiON hard mask due to poor heat resistance as in the results of Comparative Examples 2, and therefore, the subsequent patterning test was unable to proceed.

The resist upper layer film material (monolayer resist for ArF) was prepared by: dissolving a polymer (RP1), an acid generator (PAG1), and a basic compound (Amine1) into a solvent containing 0.1 mass% FC-430 (manufactured by Sumitomo 3M Ltd.) according to proportions of Table 6; and filtering the solution through a 0.1-µm filter made of a fluorinated resin.

**[Table 6]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Aminel (0.8) | PGMEA (2500) |

The polymer (RP1), acid generator (PAG1), and basic compound (Amine1) used are shown below.

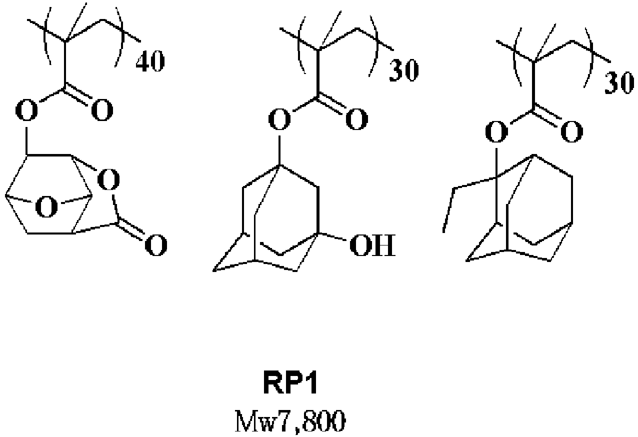

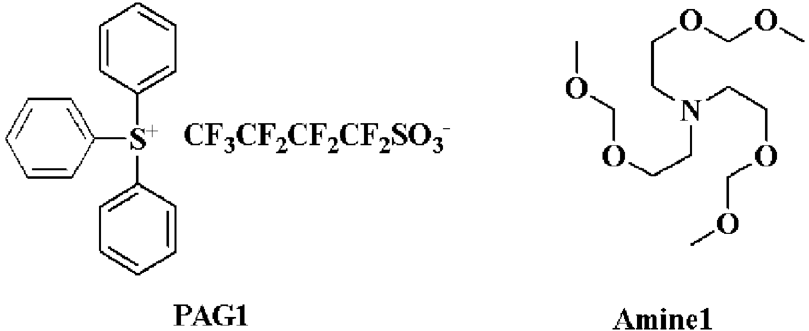

The liquid immersion top coat material (TC-1) was prepared by: dissolving a top coat polymer (PP1) into organic solvents according to proportions of Table 7; and filtering the solution through a 0.1-µm filter made of a fluorinated resin.

**[Table 7]**

| | Top coat polymer (parts by mass) | Organic solvent (parts by mass) |
|---|---|---|
| TC-1 | PP1 (100) | diisoamyl ether (2700) |
| | | 2-methyl-1-butanol (270) |

The top coat polymer (PP1) used is shown below.

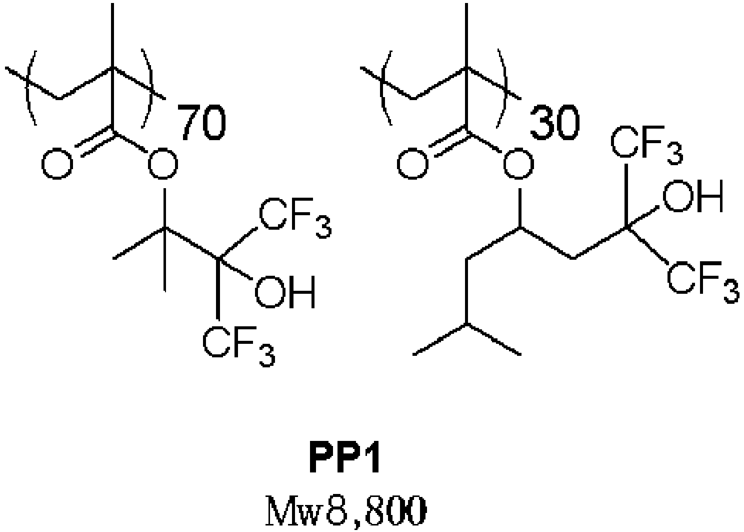

Next, the resulting substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked (PEB) at 100°C for 60 seconds, and developed with a 2.38 mass% tetramethylammonium hydroxide (TMAH) aqueous solution for 30 seconds. Thus, a 55 nm 1:1 positive line-and-space pattern (resist pattern) was obtained.

Next, the organic antireflective coating and the CVD-SiON hard mask were processed by dry etching while the resist pattern was being used as a mask with an etching apparatus Telius manufactured by Tokyo Electron Limited to form a hard mask pattern. The organic film was etched while the obtained hard mask pattern was being used as a mask to form an organic film pattern. The SiO₂ film was processed by etching while the obtained organic film pattern was being used as a mask. The etching conditions were as follows.

Conditions for transferring the resist pattern to the SiON hard mask.

| | |
|---|---|
| Chamber pressure: | 10.0 Pa |
| RF power: | 1,500 W |
| CF₄ gas flow rate: | 75 sccm |
| O₂ gas flow rate: | 15 sccm |
| Time: | 15 sec |

Conditions for transferring the hard mask pattern to the organic film.

| | |
|---|---|
| Chamber pressure: | 2.0 Pa |
| RF power: | 500 W |
| Ar gas flow rate: | 75 sccm |
| O₂ gas flow rate: | 45 sccm |
| Time: | 120 sec |

Conditions for transferring the organic film pattern to the SiO₂ film.

| | |
|---|---|
| Chamber pressure: | 2.0 Pa |
| RF power: | 2,200 W |
| C₅F₁₂ gas flow rate: | 20 sccm |
| C₂F₆ gas flow rate: | 10 sccm |
| Ar gas flow rate: | 300 sccm |
| O₂ gas flow rate: | 60 sccm |
| Time: | 90 sec |

Each pattern cross section including the non-trench and trench portions was observed with an electron microscope (S-4700) manufactured by Hitachi, Ltd. Table 8 shows the results.

**[Table 8]**

| | Material for forming organic film | Pattern profile at non-trench portion after etching-transferring to substrate | Pattern profile at trench portion after etching-transferring to substrate |
|---|---|---|---|
| Example 5-1 | UDL-1 | vertical profile | vertical profile |
| Example 5-2 | UDL-2 | vertical profile | vertical profile |
| Example 5-3 | UDL-3 | vertical profile | vertical profile |
| Example 5-4 | UDL-4 | vertical profile | vertical profile |
| Example 5-5 | UDL-5 | vertical profile | vertical profile |
| Example 5-6 | UDL- 6 | vertical profile | vertical profile |
| Example 5-7 | UDL-7 | vertical profile | vertical profile |
| Example 5-8 | UDL-8 | vertical profile | vertical profile |
| Example 5-9 | UDL-9 | vertical profile | vertical profile |
| Example 5-10 | UDL-10 | vertical profile | vertical profile |
| Example 5-11 | UDL-11 | vertical profile | vertical profile |
| Example 5-12 | UDL-12 | vertical profile | vertical profile |
| Example 5-13 | UDL-13 | vertical profile | vertical profile |
| Example 5-14 | UDL-14 | vertical profile | vertical profile |
| Example 5-15 | UDL-15 | vertical profile | vertical profile |
| Example 5-16 | UDL-16 | vertical profile | vertical profile |
| Example 5-17 | UDL-17 | vertical profile | vertical profile |
| Example 5-18 | UDL-18 | vertical profile | vertical profile |
| Example 5-19 | UDL-19 | vertical profile | vertical profile |
| Example 5-20 | UDL-20 | vertical profile | vertical profile |
| Example 5-21 | UDL-21 | vertical profile | vertical profile |
| Example 5-22 | UDL-22 | vertical profile | vertical profile |
| Example 5-23 | UDL-23 | vertical profile | vertical profile |
| Comparative Example 5-1 | Comparative UDL-1 | vertical profile | no pattern |
| Comparative Example 5-2 | Comparative UDL-2 | vertical profile | no pattern |
| Comparative Example 5-3 | Comparative UDL-4 | vertical profile | no pattern |

It was verified as shown in Table 8 that in all the results of the inventive materials for forming an organic film (Examples 5-1 to 5-23), the resist upper layer film patterns were favorably transferred to the final substrates, and that the inventive materials for forming an organic film are suitably used in fine processing by the multilayer resist method. Comparative Examples 5-1, 5-2, and 5-3, which had been demonstrated to have insufficient planarizing property by the results of Comparative Examples 4 in Planarizing Property Evaluation, resulted in large steps between the trench and non-trench portions. Even when the CVD-SiON hard mask, organic antireflective coating material, and resist upper layer film were formed thereon, there were large film thickness differences between the trench and non-trench portions. Consequently, the focus deviations at the trench portions were so large during the exposure that it was impossible to form patterns.

From the above, it was revealed that the inventive materials containing the compound for forming an organic film have all of heat resistance to 400°C or higher and high filling and planarizing properties even on a substrate to be processed having wide trench structure (wide trench); thus, the inventive materials are quite useful as organic film materials used in multilayer resist methods. Moreover, the inventive patterning processes using the materials can form fine patterns with high precision even when the substrate to be processed is a stepped substrate.

## Claims

1. A material for forming an organic film, comprising:
(A) a compound for forming an organic film shown by the following general formula (1A); and
(B) an organic solvent, 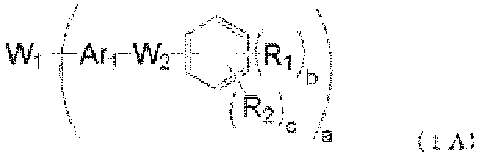 wherein Ar₁ represents a benzene ring or naphthalene ring optionally having a substituent; W₁ represents a hydrocarbon group having 1 to 15 carbon atoms optionally substituted with a fluorine atom; W₂ represents -O- or -NR₃-; each R₁ independently represents a group shown in the following formula (1B); each R₂ independently represents a halogen atom, a cyano group, or a nitro group; R₃ represents a hydrogen atom or an alkyl group having 1 to 6 carbon atoms; a=2 to 4, b=1 to 4, and c=1 to 4, with b+c≤5, 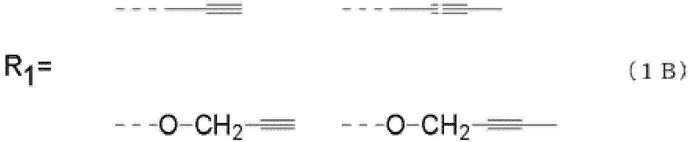 wherein a broken line represents a bonding arm.

2. The material for forming an organic film according to claim 1, wherein the R₂ of the component (A) is a fluorine atom.

3. The material for forming an organic film according to claim 1 or 2, wherein the W₁ of the component (A) is shown by the following formula (1C), 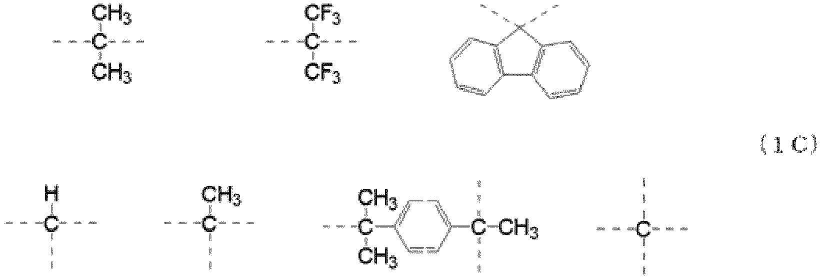 wherein a broken line represents a bonding arm.

4. The material for forming an organic film according to any one of claims 1 to 3, wherein a ratio Mw/Mn of a weight-average molecular weight Mw and a number-average molecular weight Mn of the compound for forming an organic film as the component (A) in terms of polystyrene by a gel permeation chromatography method satisfies 1.00≤Mw/Mn≤1.35.

5. The material for forming an organic film according to any one of claims 1 to 4,
a)
wherein the component (B) is a mixture of: one or more organic solvents each having a boiling point of lower than 180°C; and one or more organic solvents each having a boiling point of 180°C or higher; and/or
b)
wherein the material for forming an organic film further comprises one or more of (C) an acid generator, (D) a surfactant, (E) a crosslinking agent, and (F) a plasticizer.

6. A substrate for manufacturing a semiconductor device, comprising an organic film on the substrate, the organic film being a cured film of the material for forming an organic film according to any one of claims 1 to 5.

7. A method for forming an organic film employed in a semiconductor device manufacturing process, the method comprising:
a)
spin-coating a substrate to be processed with the material for forming an organic film according to any one of claims 1 to 5; and
heating the substrate to be processed coated with the material for forming an organic film under an inert gas atmosphere at a temperature of 50°C or higher and 600°C or lower for 10 seconds to 7200 seconds to obtain a cured film; or
b)
spin-coating a substrate to be processed with the material for forming an organic film according to any one of claims 1 to 5;
heating the substrate to be processed coated with the material for forming an organic film in air at a temperature of 50°C or higher and 300°C or lower for 5 seconds to 600 seconds to form a coating film; and
then performing a heat treatment under an inert gas atmosphere at a temperature of 200°C or higher and 600°C or lower for 10 seconds to 7200 seconds to obtain a cured film; or
c)
spin-coating a substrate to be processed with the material for forming an organic film according to any one of claims 1 to 5; and
heating the substrate to be processed coated with the material for forming an organic film in air at a temperature of 50°C or higher and 600°C or lower for 10 seconds to 7200 seconds to obtain a cured film.

8. The method for forming an organic film according to claim 7, wherein the inert gas atmosphere has an oxygen concentration of 1% or less.

9. The method for forming an organic film according to claim 7, wherein the heating is performed in air at a temperature of 50°C or higher and 600°C or lower for 10 seconds to 7200 seconds to obtain a cured film, wherein the air has an oxygen concentration of 1% or more and 21% or less.

10. The method for forming an organic film according to any one of claims 7 to 9, wherein the substrate to be processed has a structure or step with a height of 30 nm or more.

11. A patterning process for forming a pattern in a substrate to be processed, comprising:
a)
forming an organic film on the substrate to be processed by using the material for forming an organic film according to any one of claims 1 to 5;
forming a silicon-containing resist middle layer film on the organic film by using a silicon-containing resist middle layer film material;
forming a resist upper layer film on the silicon-containing resist middle layer film by using a photoresist composition;
forming a circuit pattern in the resist upper layer film;
transferring the pattern to the silicon-containing resist middle layer film by etching while using the resist upper layer film having the formed pattern as a mask;
transferring the pattern to the organic film by etching while using the silicon-containing resist middle layer film having the transferred pattern as a mask; and
further transferring the pattern to the substrate to be processed by etching while using the organic film having the transferred pattern as a mask; or
b)
forming an organic film on the substrate to be processed by using the material for forming an organic film according to any one of claims 1 to 5;
forming a silicon-containing resist middle layer film on the organic film by using a silicon-containing resist middle layer film material;
forming an organic antireflective coating on the silicon-containing resist middle layer film;
forming a resist upper layer film on the organic antireflective coating by using a photoresist composition, so that a 4-layered film structure is constructed;
forming a circuit pattern in the resist upper layer film;
transferring the pattern to the organic antireflective coating and the silicon-containing resist middle layer film by etching while using the resist upper layer film having the formed pattern as a mask;
transferring the pattern to the organic film by etching while using the silicon-containing resist middle layer film having the transferred pattern as a mask; and
further transferring the pattern to the substrate to be processed by etching while using the organic film having the transferred pattern as a mask; or
c)
forming an organic film on the substrate to be processed by using the material for forming an organic film according to any one of claims 1 to 5;
forming an inorganic hard mask middle layer film selected from a silicon oxide film, a silicon nitride film, a silicon oxynitride film, a titanium oxide film, and a titanium nitride film on the organic film;
forming a resist upper layer film on the inorganic hard mask middle layer film by using a photoresist composition;
forming a circuit pattern in the resist upper layer film;
transferring the pattern to the inorganic hard mask middle layer film by etching while using the resist upper layer film having the formed pattern as a mask;
transferring the pattern to the organic film by etching while using the inorganic hard mask middle layer film having the transferred pattern as a mask; and
further transferring the pattern to the substrate to be processed by etching while using the organic film having the transferred pattern as a mask; or
d)
forming an organic film on the substrate to be processed by using the material for forming an organic film according to any one of claims 1 to 5;
forming an inorganic hard mask middle layer film selected from a silicon oxide film, a silicon nitride film, a silicon oxynitride film, a titanium oxide film, and a titanium nitride film on the organic film;
forming an organic antireflective coating on the inorganic hard mask middle layer film;
forming a resist upper layer film on the organic antireflective coating by using a photoresist composition, so that a 4-layered film structure is constructed;
forming a circuit pattern in the resist upper layer film;
transferring the pattern to the organic antireflective coating and the inorganic hard mask middle layer film by etching while using the resist upper layer film having the formed pattern as a mask;
transferring the pattern to the organic film by etching while using the inorganic hard mask middle layer film having the transferred pattern as a mask; and
further transferring the pattern to the substrate to be processed by etching while using the organic film having the transferred pattern as a mask.

12. The patterning process according to claim 11, wherein the inorganic hard mask middle layer film is formed by a CVD method or an ALD method.

13. The patterning process according to claim 11 or 12, wherein the circuit pattern is formed by a lithography using light with a wavelength of 10 nm or more to 300 nm or less, a direct drawing with electron beam, nanoimprinting, or a combination thereof.

14. The patterning process according to any one of claims 11 to 13, wherein when the circuit pattern is formed, the circuit pattern is developed by alkali development or with an organic solvent.

15. The patterning process according to any one of claims 11 to 14, wherein the substrate to be processed is a semiconductor device substrate or the semiconductor device substrate coated with any of a metal film, a metal carbide film, a metal oxide film, a metal nitride film, a metal oxycarbide film, and a metal oxynitride film; preferably
wherein a metal of the substrate to be processed comprises silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

## Patentansprüche

1. Material zur Bildung eines organischen Films, das umfasst:
(A) eine Verbindung zur Bildung eines organischen Films, dargestellt durch die folgende allgemeine Formel (1A); und
(B) ein organisches Lösungsmittel , 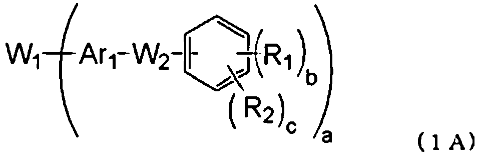 wobei Ar₁ einen Benzolring oder Naphthalinring repräsentiert, der optional einen Substituenten aufweist; W₁ eine Kohlenwasserstoffgruppe mit 1 bis 15 Kohlenstoffatomen repräsentiert, die optional mit einem Fluoratom substituiert ist; W₂ -O- oder - NR₃ - repräsentiert; jedes R₁ unabhängig eine in der folgenden Formel (1B) dargestellte Gruppe repräsentiert; jedes R₂ unabhängig ein Halogenatom, eine Cyanogruppe oder eine Nitrogruppe repräsentiert; R₃ ein Wasserstoffatom oder eine Alkylgruppe mit 1 bis 6 Kohlenstoffatomen darstellt; a=2 bis 4, b=1 bis 4 und c=1 bis 4 ist, wobei b+c≤5 ist, 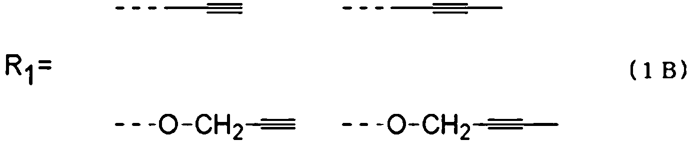 wobei eine gestrichelte Linie einen Bindungsarm repräsentiert.

2. Material zur Bildung eines organischen Films gemäß Anspruch 1, wobei das R₂ der Komponente (A) ein Fluoratom

3. Material zur Bildung eines organischen Films gemäß Anspruch 1 oder 2, wobei das W₁ der Komponente (A) durch die folgende Formel (1C) dargestellt wird, 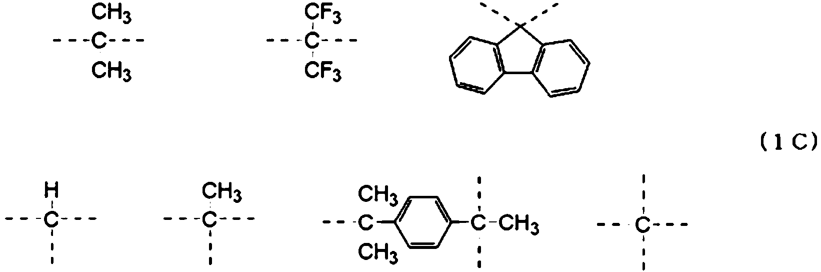 wobei eine gestrichelte Linie einen Bindungsarm repräsentiert.

4. Material zur Bildung eines organischen Films gemäß einem der Ansprüche 1 bis 3, wobei ein Verhältnis Mw/Mn eines gewichtsmittleren Molekulargewichts Mw und eines zahlenmittleren Molekulargewichts Mn der Verbindung zur Bildung eines organischen Films als Komponente (A) in Bezug auf Polystyrol mittels eines Gelpermeationschromatographieverfahrens 1,00 ≤ Mw/Mn ≤ 1,35 erfüllt .

5. Material zur Bildung eines organischen Films gemäß einem der Ansprüche 1 bis 4,
a)
wobei die Komponente (B) eine Mischung aus einem oder mehreren organischen Lösungsmitteln mit einem Siedepunkt von weniger als 180 °C und einem oder mehreren organischen Lösungsmitteln mit einem Siedepunkt von 180 °C oder mehr ist ; und/oder
b)
wobei das Material zur Bildung eines organischen Films ferner eines oder mehrere der folgenden Elemente umfasst (C) einen Säuregenerator, (D) ein Tensid, (E) ein Vernetzungsmittel und (F) einen Weichmacher.

6. Substrat zur Herstellung einer Halbleitervorrichtung, die einen organischen Film auf dem Substrat umfasst, wobei der organische Film ein gehärteter Film aus dem Material zur Bildung eines organischen Films gemäß einem der Ansprüche 1 bis 5 ist.

7. Verfahren zur Bildung eines organischen Films, der in einem Halbleiterbauelement-Herstellungsprozess verwendet wird, wobei das Verfahren umfasst:
a)
Rotationsbeschichten eines zu bearbeitenden Substrats mit dem Material zur Bildung eines organischen Films gemäß einem der Ansprüche 1 bis 5; und
Erhitzen des zu bearbeitenden Substrats, das mit dem Material zur Bildung eines organischen Films beschichtet ist, unter einer Inertgasatmosphäre bei einer Temperatur von 50 °C oder höher und 600 °C oder niedriger für 10 Sekunden bis 7200 Sekunden, um einen ausgehärteten Film zu erhalten; oder
b)
Rotationsbeschichten eines zu bearbeitenden Substrats mit dem Material zur Bildung eines organischen Films gemäß einem der Ansprüche 1 bis 5;
Erhitzen des zu bearbeitenden Substrats, das mit dem Material zur Bildung eines organischen Films beschichtet ist, in Luft bei einer Temperatur von 50 °C oder höher und 300 °C oder niedriger für 5 Sekunden bis 600 Sekunden, um einen Beschichtungsfilm zu bilden; und
anschließendes Durchführen einer Wärmebehandlung unter einer Inertgasatmosphäre bei einer Temperatur von 200 °C oder höher und 600 °C oder niedriger für 10 Sekunden bis 7200 Sekunden, um einen ausgehärteten Film zu erhalten; oder
c)
Rotationsbeschichten eines zu bearbeitenden Substrats mit dem Material zur Bildung eines organischen Films gemäß einem der Ansprüche 1 bis 5; und
Erhitzen des zu bearbeitenden Substrats, das mit dem Material zum Bilden eines organischen Films beschichtet ist, in Luft bei einer Temperatur von 50 °C oder höher und 600 °C oder niedriger für 10 Sekunden bis 7200 Sekunden, um einen ausgehärteten Film zu erhalten.

8. Verfahren zur Bildung eines organischen Films gemäß Anspruch 7, wobei die Inertgasatmosphäre eine Sauerstoffkonzentration von 1 % oder weniger aufweist .

9. Verfahren zur Bildung eines organischen Films gemäß Anspruch 7, wobei das Erhitzen in Luft bei einer Temperatur von 50 °C oder höher und 600 °C oder niedriger für 10 Sekunden bis 7200 Sekunden durchgeführt wird, um eine ausgehärteten Film zu erhalten, wobei die Luft eine Sauerstoffkonzentration von 1 % oder mehr und 21 % oder weniger aufweist .

10. Verfahren zur Bildung eines organischen Films gemäß einem der Ansprüche 7 bis 9, wobei das zu bearbeitende Substrat eine Struktur oder Stufe mit einer Höhe von 30 nm oder mehr aufweist.

11. Strukturierungsverfahren zur Bildung eines Musters in einem zu bearbeitenden Substrat, das umfasst:
a)
Bilden eines organischen Films auf dem zu bearbeitenden Substrat unter Verwendung des Materials zur Bildung eines organischen Films gemäß einem der Ansprüche 1 bis 5;
Bilden eines siliziumhaltigen Resistmittelschichtfilms auf dem organischen Film unter Verwendung eines siliziumhaltigen Resistmittelschichtfilmmaterials;
Bilden eines Resistoberschichtfilms auf dem siliziumhaltigen Resistmittelschichtfilm unter Verwendung einer Photoresist-Zusammensetzung;
Bilden eines Schaltungsmusters in dem Resistoberschichtfilm;
Übertragen des Musters auf den siliziumhaltigen Resistmittelschichtfilm durch Ätzen, wobei der Resistoberschichtfilm mit dem gebildeten Muster als Maske verwendet wird;
Übertragen des Musters auf den organischen Film durch Ätzen, wobei der siliziumhaltige Resistmittelschichtfilm mit dem übertragenen Muster als Maske verwendet wird; und
weiteres Übertragen des Musters auf das zu bearbeitende Substrat durch Ätzen, wobei der organische Film mit dem übertragenen Muster als Maske verwendet wird; oder
b)
Bilden eines organischen Films auf dem zu bearbeitenden Substrat unter Verwendung des Materials zur Bildung eines organischen Films gemäß einem der Ansprüche 1 bis 5;
Bilden eines siliziumhaltigen Resistmittelschichtfilms auf dem organischen Film unter Verwendung eines siliziumhaltigen Resistmittelschichtfilmmaterials;
Bilden einer organischen Antireflexbeschichtung auf dem siliziumhaltigen Resistmittelschichtfilm;
Bilden eines Resistoberschichtfilms auf der organischen Antireflexbeschichtung unter Verwendung einer Photoresistzusammensetzung, so dass eine 4-schichtige Filmstruktur aufgebaut wird;
Bilden eines Schaltungsmusters in dem Resistoberschichtfilm;
Übertragen des Musters auf die organische Antireflexbeschichtung und den siliziumhaltigen Resistmittelschichtfilm durch Ätzen unter Verwendung des Resistoberschichtfilms mit dem gebildeten Muster als Maske;
Übertragen des Musters auf den organischen Film durch Ätzen, wobei der siliziumhaltige Resistmittelschichtfilm mit dem übertragenen Muster als Maske verwendet wird; und
weiteres Übertragen des Musters auf das zu bearbeitende Substrat durch Ätzen, wobei der organische Film mit dem übertragenen Muster als Maske verwendet wird; oder
c)
Bilden eines organischen Films auf dem zu bearbeitenden Substrat unter Verwendung des Materials zum Bilden eines organischen Films gemäß einem der Ansprüche 1 bis 5;
Bilden eines anorganischen Hartmasken-Zwischenschichtfilms, ausgewählt aus einem Siliziumoxidfilm, einem Siliziumnitridfilm, einem Siliziumoxynitridfilm, einem Titanoxidfilm und einem Titannitridfilm, auf dem organischen Film;
Bilden eines Resistoberschichtfilms auf dem anorganischen Hartmasken-Zwischenschichtfilm unter Verwendung einer Photoresistzusammensetzung;
Bilden eines Schaltungsmusters in dem Resistoberschichtfilm;
Übertragen des Musters auf den anorganischen Hartmasken-Zwischenschichtfilm durch Ätzen, wobei der Resistoberschichtfilm mit dem gebildeten Muster als Maske verwendet wird;
Übertragen des Musters auf den organischen Film durch Ätzen, wobei der anorganische Hartmasken-Zwischenschichtfilm mit dem übertragenen Muster als Maske verwendet wird; und
weiteres Übertragen des Musters auf das zu bearbeitende Substrat durch Ätzen, wobei der organische Film mit dem übertragenen Muster als Maske verwendet wird; oder
d)
Bilden eines organischen Films auf dem zu bearbeitenden Substrat unter Verwendung des Materials zum Bilden eines organischen Films gemäß einem der Ansprüche 1 bis 5;
Bilden eines anorganischen Hartmasken-Mittelschichtfilms, ausgewählt aus einem Siliziumoxidfilm, einem Siliziumnitridfilm, einem Siliziumoxynitridfilm, einem Titanoxidfilm und einem Titannitridfilm, auf dem organischen Film;
Bilden einer organischen Antireflexbeschichtung auf dem anorganischen Hartmasken-Resistmittelschichtfilm;
Bilden eines Resistoberschichtfilms auf der organischen Antireflexbeschichtung unter Verwendung einer Photoresistzusammensetzung, so dass eine 4-schichtige Filmstruktur aufgebaut wird;
Bilden eines Schaltungsmusters in dem Resistoberschichtfilm;
Übertragen des Musters auf die organische Antireflexbeschichtung und den anorganischen Hartmasken-Zwischenschichtfilm durch Ätzen, wobei der Resistoberschichtfilm mit dem gebildeten Muster als Maske verwendet wird;
Übertragen des Musters auf den organischen Film durch Ätzen unter Verwendung des anorganischen Hartmasken-Zwischenschichtfilms mit dem übertragenen Muster als Maske; und
weiteres Übertragen des Musters auf das zu bearbeitende Substrat durch Ätzen unter Verwendung des organischen Films mit dem übertragenen Muster als Maske.

12. Strukturierungsverfahren gemäß Anspruch 11, wobei der anorganische Hartmasken-Zwischenschichtfilm durch ein CVD-Verfahren oder ein ALD-Verfahren gebildet wird.

13. Strukturierungsverfahren gemäß Anspruch 11 oder 12, wobei das Schaltungsmuster durch Lithografie unter Verwendung von Licht mit einer Wellenlänge von 10 nm oder mehr bis 300 nm oder weniger, durch direktes Zeichnen mit einem Elektronenstrahl, durch Nanoimprinting oder durch eine Kombination davon gebildet wird.

14. Strukturierungsverfahren nach einem der Ansprüche 11 bis 13, wobei bei der Bildung des Schaltungsmusters das Schaltungsmuster durch Alkali-Entwicklung oder mit einem organischen Lösungsmittel entwickelt wird.

15. Strukturierungsverfahren nach einem der Ansprüche 11 bis 14, wobei das zu bearbeitende Substrat ein Halbleiterbauelement-Substrat oder das mit einem Metallfilm, einem Metallkarbidfilm, einem Metalloxidfilm, einem Metallnitridfilm, einem Metalloxycarbidfilm oder einem Metalloxynitridfilm beschichtetes Halbleiterbauelement-Substrat ist;
vorzugsweise
wobei ein Metall des zu bearbeitenden Substrats Silizium, Titan, Wolfram, Hafnium, Zirkonium, Chrom, Germanium, Kupfer, Silber, Gold, Aluminium, Indium, Gallium, Arsen, Palladium, Eisen, Tantal, Iridium, Kobalt, Mangan, Molybdän oder eine Legierung davon umfasst.

## Revendications

1. Matériau servant à former un film organique, comprenant:
(A) un composé servant à former un film organique représenté par la formule générale suivante (1A); et
(B) un solvant organique, 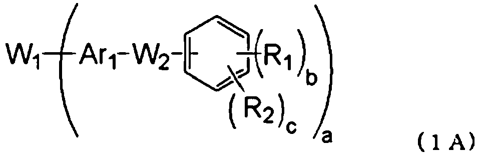 dans laquelle Ar₁ représente un cycle benzène ou un cycle naphtalène comportant éventuellement un substituant; W₁ représente un groupe hydrocarbure ayant 1 à 15 atomes de carbone éventuellement substitué par un atome de fluor; W₂ représente - O- ou -NR₃-; chaque R₁ représente indépendamment un groupe représenté par la formule (1B) suivante; chaque R₂ représente indépendamment un atome d'halogène, un groupe cyano ou un groupe nitro; R₃ représente un atome d'hydrogène ou un groupe alkyle ayant 1 à 6 atomes de carbone; a = 2 à 4, b = 1 à 4 et c = 1 à 4, b + c ≤ 5, 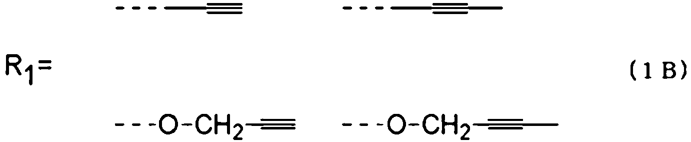 dans laquelle une ligne discontinue représente un point de liaison.

2. Matériau servant à former un film organique selon la revendication 1, dans lequel R₂ du composé (A) est un atome de fluor.

3. Matériau servant à former un film organique selon la revendication 1 ou 2, dans lequel W₁ du composé (A) est représenté par la formule suivante (1C), 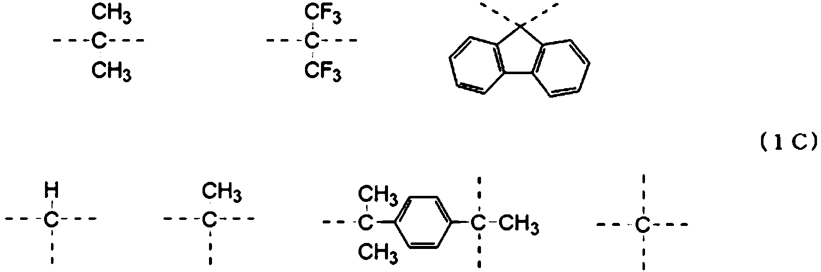 dans laquelle une ligne discontinue représente un point de liaison.

4. Matériau servant à former un film organique selon l'une quelconque des revendications 1 à 3, dans lequel le rapport Mw/Mn entre la masse moléculaire moyenne en poids Mw et la masse moléculaire moyenne en nombre Mn du composé servant à former un film organique en tant que composé (A) par rapport au polystyrène, déterminé par chromatographie par perméation de gel, remplit la condition 1,00 ≤ Mw/Mn ≤ 1,35.

5. Matériau servant à former un film organique selon l'une quelconque des revendications 1 à 4,
a)
dans lequel le composé (B) est un mélange : d'un ou plusieurs solvants organiques ayant chacun un point d'ébullition inférieur à 180 °C ; et d'un ou plusieurs solvants organiques ayant chacun un point d'ébullition supérieur ou égal à 180 °C; et/ou
b)
dans lequel le matériau servant à former un film organique comprend en outre un ou plusieurs parmi (C) un générateur d'acide, (D) un tensioactif, (E) un agent de réticulation et (F) un plastifiant.

6. Substrat servant à fabriquer un dispositif à semi-conducteur, comprenant un film organique sur le substrat, le film organique étant formé par durcissement du matériau servant à former un film organique selon l'une quelconque des revendications 1 à 5.

7. Procédé servant à former un film organique utilisé dans un processus de fabrication de dispositif à semi-conducteur, le procédé comprenant:
a)
le revêtement par centrifugation d'un substrat à traiter avec le matériau servant à former un film organique selon l'une quelconque des revendications 1 à 5, et
le chauffage du substrat à traiter revêtu du matériau servant à former un film organique sous une atmosphère de gaz inerte à une température supérieure ou égale à 50 °C et inférieure ou égale à 600 °C pendant 10 à 7 200 secondes afin d'obtenir un film durci; ou
b)
le revêtement par centrifugation d'un substrat à traiter avec le matériau servant à former un film organique selon l'une quelconque des revendications 1 à 5;
le chauffage du substrat à traiter revêtu du matériau pour former un film organique dans l'air à une température supérieure ou égale à 50 °C et inférieure ou égale à 300 °C pendant 5 à 600 secondes afin de former un film de revêtement; et
puis le traitement thermique sous atmosphère inerte à une température supérieure ou égale à 200 °C et inférieure ou égale à 600 °C pendant 10 à 7 200 secondes afin d'obtenir un film durci; ou
c)
le revêtement par centrifugation d'un substrat à traiter avec le matériau servant à former un film organique selon l'une quelconque des revendications 1 à 5; et
le chauffage à l'air du substrat à traiter revêtu du matériau servant former un film organique à une température supérieure ou égale à 50°C et inférieure ou égale à 600°C pendant 10 à 7 200 secondes afin d'obtenir un film durci.

8. Procédé de formation d'un film organique selon la revendication 7, dans lequel l'atmosphère de gaz inerte a une concentration en oxygène inférieure ou égale à 1 %.

9. Procédé de formation d'un film organique selon la revendication 7, dans lequel le chauffage à l'air est effectué à une température supérieure ou égale à 50°C et inférieure ou égale à 600°C pendant 10 à 7 200 secondes afin d'obtenir un film durci, l'air ayant une concentration en oxygène supérieure ou égale à 1 % et inférieure ou égale à 21 %.

10. Procédé de formation d'un film organique selon l'une quelconque des revendications 7 à 9, dans lequel le substrat à traiter présente une structure ou un niveau d'une hauteur supérieure ou égale à 30 nm.

11. Processus de formation de motif permettant de former un motif dans un substrat à traiter, comprenant:
a)
la formation d'un film organique sur le substrat à traiter à l'aide du matériau servant à former un film organique selon l'une quelconque des revendications 1 à 5;
la formation d'un film de couche intermédiaire de résine photosensible contenant du silicium sur le film organique à l'aide d'un matériau de film de couche intermédiaire de résine photosensible contenant du silicium;
la formation d'un film de couche supérieure de résine photosensible sur le film de couche intermédiaire de résine photosensible contenant du silicium à l'aide d'une composition de résine photosensible;
la formation d'un tracé de circuit dans le film de couche supérieure de résine photosensible;
le transfert du motif sur le film de couche intermédiaire de résine photosensible contenant du silicium par gravure tout en utilisant le film de couche supérieure de résine photosensible sur lequel est formé le motif en tant que masque;
le transfert du motif sur le film organique par gravure tout en utilisant le film intermédiaire résistant contenant du silicium sur lequel est transféré le motif en tant que masque; et
le transfert ultérieur du motif sur le substrat à traiter par gravure tout en utilisant le film organique comportant le motif transféré en tant que masque; ou
b)
la formation d'un film organique sur le substrat à traiter à l'aide du matériau servant à former un film organique selon l'une quelconque des revendications 1 à 5;
la formation d'un film de couche intermédiaire de résine photosensible contenant du silicium sur le film organique à l'aide d'un matériau de film de couche intermédiaire de résine photosensible contenant du silicium;
la formation d'un revêtement antireflet organique sur le film de couche intermédiaire de résine photosensible contenant du silicium;
la formation d'un film de couche supérieure résistante sur le revêtement antireflet organique à l'aide d'une composition de résine photosensible, de manière à obtenir une structure à quatre couches;
la formation d'un tracé de circuit dans le film de couche supérieure de résine photosensible;
le transfert du motif sur le revêtement antireflet organique et le film de couche intermédiaire de résine photosensible contenant du silicium par gravure tout en utilisant le film de couche supérieure de résine photosensible sur lequel est formé le motif en tant que masque;
le transfert du motif sur le film organique par gravure tout en utilisant le film intermédiaire résistant contenant du silicium sur lequel est transféré le motif en tant que masque; et
le transfert ultérieur du motif sur le substrat à traiter par gravure tout en utilisant le film organique comportant le motif transféré en tant que masque; ou
c)
la formation d'un film organique sur le substrat à traiter à l'aide du matériau servant à former un film organique selon l'une quelconque des revendications 1 à 5;
la formation d'un film de couche intermédiaire de masque dur inorganique choisi parmi un film d'oxyde de silicium, un film de nitrure de silicium, un film d'oxynitrure de silicium, un film d'oxyde de titane et un film de nitrure de titane sur le film organique;
la formation d'un film de couche supérieure de résine photosensible sur le film de couche intermédiaire de masque dur inorganique à l'aide d'une composition de résine photosensible;
la formation d'un tracé de circuit dans le film de couche supérieure de résine photosensible;
le transfert du motif sur le film de couche intermédiaire de masque dur par gravure tout en utilisant le film de couche supérieure de résine photosensible sur lequel est formé le motif en tant que masque;
le transfert du motif sur le film organique par gravure tout en utilisant le film de couche intermédiaire de masque dur sur lequel est transféré le motif en tant que masque; et
le transfert ultérieur du motif sur le substrat à traiter par gravure tout en utilisant le film organique comportant le motif transféré en tant que masque; ou
d)
la formation d'un film organique sur le substrat à traiter à l'aide du matériau servant à former un film organique selon l'une quelconque des revendications 1 à 5;
la formation d'un film de couche intermédiaire de masque dur inorganique choisi parmi un film d'oxyde de silicium, un film de nitrure de silicium, un film d'oxynitrure de silicium, un film d'oxyde de titane et un film de nitrure de titane sur le film organique;
la formation d'un revêtement antireflet organique sur le film de couche intermédiaire de masque dur inorganique;
la formation d'un film de couche supérieure résistante sur le revêtement antireflet organique à l'aide d'une composition de résine photosensible, de manière à obtenir une structure à quatre couches;
la formation d'un tracé de circuit dans le film de couche supérieure de résine photosensible;
le transfert du motif sur le revêtement antireflet organique et le film de couche intermédiaire de masque dur inorganique par gravure tout en utilisant le film de couche supérieure de résine photosensible sur lequel est formé le motif en tant que masque;
le transfert du motif sur le film organique par gravure tout en utilisant le film de couche intermédiaire de masque dur sur lequel est transféré le motif en tant que masque; et
le transfert ultérieur du motif sur le substrat à traiter par gravure tout en utilisant le film organique sur lequel est transféré le motif en tant que masque.

12. Procédé de formation de motif selon la revendication 11, dans lequel le film de couche intermédiaire de masque dur inorganique est formé par un procédé CVD ou un procédé ALD.

13. Procédé de formation de motif selon la revendication 11 ou 12, dans lequel le tracé de circuit est formé par lithographie à l'aide d'une lumière dont la longueur d'onde est supérieure ou égale à 10 nm et inférieure ou égale à 300 nm, par dessin direct à l'aide d'un faisceau d'électrons, par nano-impression ou par leur combinaison.

14. Procédé de formation de motif selon l'une quelconque des revendications 11 à 13, dans lequel, lorsque le tracé de circuit est formé, le tracé de circuit est développé par développement alcalin ou avec un solvant organique.

15. Procédé de formation de motif selon l'une quelconque des revendications 11 à 14, dans lequel le substrat à traiter est un substrat de dispositif à semi-conducteur ou le substrat de dispositif à semi-conducteur recouvert d'un quelconque film parmi un film métallique, un film de carbure métallique, un film d'oxyde métallique, d'un film de nitrure métallique, un film d'oxycarbure métallique et un film d'oxynitrure métallique;
de préférence
dans lequel un métal du substrat à traiter comprend du silicium, du titane, du tungstène, du hafnium, du zirconium, du chrome, du germanium, du cuivre, de l'argent, de l'or, de l'aluminium, de l'indium, du gallium, de l'arsenic, du palladium, du fer, du tantale, de l'iridium, du cobalt, du manganèse, du molybdène ou leur alliage.
